# FASCICULE DE BREVET EUROPEEN

(11) **EP 2 194 651 B1**
(45) Date de publication et mention de la délivrance du brevet: **15.02.2012**
(21) Numéro de dépôt: 09290811.0
(22) Date de dépôt: 22.10.2009
(51) Int. Cl.: H04B 1/38, H05K 9/00

(54) **Dispositif de protection biologique contre les ondes électromagnétiques émises par un téléphone mobile**
Einrichtung zum biologischen Schutz gegen die durch ein Mobiltelefon ausgesendeten elektromagnetischen Wellen
Device for biological protection against electromagnetic waves emitted by a mobile phone

(30) Priorité: 23.10.2008 FR 0805878
(43) Date de publication de la demande: 09.06.2010
(73) Titulaire: Dephasium Ltd., London W2 1HR (GB)
(72) Inventeur: Mourali, Cyril, 75001 Paris (FR); Parienti, Serge, 92100 Boulogne-Billancourt (FR); Saillard, Joseph, 44800 Saint Herblain (FR); Chauveau, Janic, 44130 Blain (FR); Brunet, Marc, 44450 Saint Julien de Concelles (FR); Collette, Henri, 78800 Houilles (FR)
(74) Mandataire: Debay, Yves

(56) Documents cités:
- WO-A1-02/095867
- DE-U1- 20 306 964
- GB-A- 2 363 003
- US-A1- 2002 137 475

## Description

La présente invention concerne le domaine des dispositifs de protection biologique individuelle contre les émissions de pollution électromagnétique.

La présente invention concerne plus particulièrement un dispositif de protection biologique contre les ondes électromagnétiques émises par un téléphone mobile.

Dans un monde sans fil, où les individus sont en connexion constante, les technologies mobiles de toutes sortes se multiplient, et par conséquent, la génération d'ondes électromagnétiques. Ainsi, la plupart des habitants des pays développés possèdent un équipement complet d'appareils rayonnants : téléphones mobiles et sans fil (plus de 2 milliards d'abonnés actuellement, 3 milliards prévus en 2010), ordinateurs (1 milliard d'ordinateurs vendus), modems WIFI (1 milliard d'abonnés à internet, à terme tous en WIFI), consoles de jeux, oreillettes Bluetooth, ...

La densification des sources électromagnétiques dans notre environnement pose la question concrète des effets sur la santé et le cas du téléphone mobile est le plus significatif. En effet, ce segment du marché des télécommunications connaît une croissance fulgurante et le téléphone mobile soulève depuis sa diffusion sur le marché les doutes les plus virulents concernant l'exposition des individus à ses rayonnements électromagnétiques puissants, continus et proches du cerveau.

La question de la nocivité n'a à ce jour pas trouvé de réponse concrète et définitive et la polémique est à son paroxysme. De nombreuses études internationales, réalisées sur le sujet, oscillent dans leurs conclusions entre « catastrophe sanitaire » et « faibles dangers », sans jamais établir le risque zéro.

En France, suite à la parution du décret du 8 octobre 2003, les téléphones mobiles doivent présenter un indice de débit d'absorption spécifique (DAS) inférieur à 2 W/kg sur 10 g de tissu humain au niveau du tronc et de la tête, le DAS étant une grandeur fondamentale associée à l'échauffement des tissus. Aux Etats-Unis, la commission fédérale des communications requiert que les téléphones mobiles vendus aient un DAS égal ou inférieur à 1,6 W/kg sur un volume d'un gramme de tissu humain. Les derniers téléphones mobiles parus sur le marché, émettent un rayonnement électromagnétique encore responsable d'un débit d'absorption spécifique de l'ordre de 1 W/kg. Quoi qu'il en soit, le manque de recul et les incertitudes nous rappellent au principe de précaution, principe constitutionnel incontournable, au nom duquel il apparaît nécessaire de développer des dispositifs de protection biologique individuelle permettant de limiter l'exposition de l'organisme aux pollutions électromagnétiques.

Il est connu dans l'art antérieur, comme par exemple avec la demande de brevet US 2002/0137475, un boîtier de protection contre les ondes électromagnétiques, pour les téléphones mobiles, composé de deux logements, destiné à recevoir le téléphone. Les deux logements ont reçu un traitement de façon à protéger l'utilisateur contre les ondes électromagnétiques générées par le téléphone. Le premier logement possède une zone non traitée couvrant une partie du téléphone recevant et envoyant les signaux. Le deuxième logement possède un trou, dans sa partie supérieure, permettant de laisser passer le son, un volet, dans sa partie inférieure de façon à accéder au clavier du téléphone et une fenêtre, entre le volet et l'ouverture pour le son, afin de voir l'écran du téléphone, le trou la fenêtre et le volet ayant reçu un traitement pour faire écran aux ondes électromagnétiques.

La demande de brevet GB 2 363 003, enseigne une protection contre les ondes électromagnétiques, notamment pour un téléphone mobile, comprenant un ou plusieurs éléments de protection de façon à protéger l'utilisateur des effets potentiellement nuisibles du rayonnement du téléphone mobile

Il est également connu dans l'art antérieur, notamment avec la demande de brève internationale WO 02/095 867, un boîtier de protection contre les ondes électromagnétiques comprenant des moyens de loger un téléphone mobile. Ce boîtier possède une première face, destinée à être maintenue vers la tête d'un utilisateur, dotée d'une couche faisant écran au rayonnement disposée entre le téléphone mobile et la tête de l'utilisateur. Ce boîtier contient, en outre, des moyens d'émission et de réception de son provenant du téléphone mobile, placés sur le boîtier.

L'art antérieur enseigne également des systèmes d'antennes passives de protection biologique contre un large spectre de fréquences des ondes électromagnétiques se présentant sous la forme d'une gamme de patchs qu'il suffit d'appliquer sur l'équipement de technologie mobile et entre ledit équipement et l'utilisateur, pour protéger l'utilisateur des ondes électromagnétiques émises par l'équipement. Ces systèmes utilisent le principe physique du déphasage à 180° des ondes électromagnétiques.

Toutefois, du fait de la petite taille du patch par rapport à la taille de l'équipement mobile, les performances en sont forcément limitées. De plus, ces techniques s'adaptent pas ou mal aux protocoles standards de mesure de DAS.

La présente invention a pour but de pallier un ou plusieurs inconvénients de l'art antérieur en proposant un dispositif de protection biologique contre les ondes électromagnétiques émises par un téléphone mobile.

Ce but est atteint par un dispositif de protection biologique contre les ondes électromagnétiques émises par un téléphone mobile, caractérisé en ce qu'il comporte un élément de protection étanche aux ondes électromagnétiques réalisé, au moins en partie, en matériau métallique bon conducteur et agencé de façon à former un réceptacle ouvert globalement concave, approximativement de la forme d'un parallélépipède rectangle à angles arrondis dont la base forme un écran de protection plan ou légèrement concave disposé entre le téléphone mobile et son utilisateur, et dont le pourtour de l'épaisseur forme un cadre de protection de section curviligne, le téléphone mobile étant maintenu dans la concavité de l'élément de protection par au moins un organe de maintien ou de fixation en matériau isolant non conducteur disposé dans le réceptacle de façon à maintenir entre le téléphone mobile et la partie métallique de l'élément de protection un espace électriquement isolant d'une épaisseur d'au moins 2 mm ; l'écran et le cadre étant réalisés au moins en partie en matériau bon conducteur et agencés de façon à ce que la partie réalisée en matériau bon conducteur de l'écran soit en contact conducteur d'électricité avec la partie réalisée en matériau bon conducteur du cadre pour former un tout étanche aux ondes électromagnétiques et globalement concave et courbé constituant en partie l'élément de protection.

Selon une autre particularité, la longueur de l'élément de protection est égale ou supérieure à 1,15 fois la longueur du téléphone mobile, la largeur de l'élément de protection est égale ou supérieure à 1,2 fois la largeur du téléphone mobile, et la profondeur de l'élément de protection est égale ou supérieure à 1,3 fois l'épaisseur du téléphone mobile.

Selon une autre particularité, la longueur de l'élément de protection est inférieure ou égale à 1,3 fois la longueur du téléphone mobile, la largeur de l'élément de protection est inférieure ou égale à 1,3 fois la largeur du téléphone mobile et la profondeur de l'élément de protection est inférieure ou égale à 1,6 fois l'épaisseur du téléphone mobile.

Selon une autre particularité, l'espace électriquement isolant entre la partie métallique de l'élément de protection et l'interface ergonomique du téléphone mobile est d'une épaisseur comprise entre 3 mm et 8 mm.

Selon une autre particularité du dispositif, l'écran et/ou le cadre de l'élément de protection peut comporter un ou plusieurs orifices de taille inférieure aux différentes longueurs d'onde des ondes électromagnétiques des différentes normes de téléphonie mobile, l(es)' orifice(s) étant soit situé(s) en vis-à-vis du microphone et/ou du haut-parleur et/ou tout autre dispositif compris dans le téléphone mobile et chargé de recevoir et/ou émettre des ondes acoustiques, de façon à ce que ces ondes acoustiques ne soient pas altérées par l'élément de protection, soit situé(s) en face des connectiques du téléphone mobile.

Selon un premier mode de réalisation du dispositif, l'écran de l'élément de protection comprend au moins un réseau maillé réalisé en un matériau bon conducteur et ayant un pas de grille régulier ou non, inférieur ou égal à 10 mm, le matériau bon conducteur constituant des lignes conductrices pouvant être d'une largeur de 0,5 mm et d'une épaisseur de 50 µm.

Selon une particularité du premier mode de réalisation, le réseau maillé conducteur est incorporé dans, ou imprimé par sérigraphie sur, une membrane ou intercalé dans une grille de trame plus fine réalisée en un matériau souple transparent dans le domaine du visible de façon à permettre à l'utilisateur de voir l'interface ergonomique du téléphone mobile et plus particulièrement l'écran d'affichage du téléphone mobile.

Selon une autre particularité du premier mode de réalisation, l'écran plan ou légèrement concave est monté solidaire et tendu sur le cadre de l'élément de protection, qui comprend au moins une partie en matériau métallique bon conducteur à sa surface ou dans son épaisseur, de façon à ce que le réseau maillé métallique constituant en partie l'écran soit en contact conducteur d'électricité avec la partie métallique du cadre, pour former un tout étanche aux ondes électromagnétiques et globalement concave et courbé constituant en partie l'élément de protection.

Selon un deuxième mode de réalisation du dispositif, l'écran de l'élément de protection comprend au moins un film mince.

Selon une particularité du deuxième mode de réalisation, le film mince comprend au moins une partie de sa surface réalisée en matériau métallique bon conducteur, déposée sur, ou incorporée dans, une membrane réalisée en matériau souple, de façon à ce que le film mince soit suffisamment souple pour être enroulable sur lui-même.

Selon une autre particularité du deuxième mode de réalisation, le cadre de l'élément de protection comprend au moins une partie en matériau métallique bon conducteur à sa surface ou dans son épaisseur et est agencé en une combinaison fonctionnelle avec au moins un mécanisme de store.

Selon une autre particularité du deuxième mode de réalisation, chaque mécanisme de store comprend un magasin de dimension et de forme adaptées pour pouvoir contenir au moins un store entièrement enroulé autour d'un enrouleur-dérouleur fixé par des moyens de fixation approximativement au centre du magasin et situé dans le plan de glissement du store, et un jeu de deux rails de coulissement parallèles au store et situés dans le plan de glissement du store pour guider le déplacement du store, la rigidité du store étant suffisante pour commander l'enroulement en remontant l'extrémité libre du store et le magasin du mécanisme de store étant intégré à l'intérieur d'un des quatre côtés du pourtour du cadre de protection.

Selon une autre particularité du deuxième mode de réalisation de l'invention, les deux rails de coulissement sont réalisés au moins en partie en matériau bon conducteur, fixés sur le cadre de façon à assurer un contact conducteur d'électricité avec la partie métallique du cadre, et, chaque rail de coulissement est équipé d'une pluralité de lèvres conductrices distribuées à intervalles réguliers dans la longueur du rail de coulissement entre les jambes de la forme en U dessinée par le rail de coulissement, chaque lèvre conductrice étant fixée en contact conducteur d'électricité sur une première des deux jambes de la forme en U et étant de forme et de dimension adaptées pour laisser un espace constant entre elles et la deuxième des deux jambes de la forme en U d'une épaisseur au moins égale à l'épaisseur du store.

Selon une autre particularité du deuxième mode de réalisation, le mécanisme de store est agencé de façon à ce que le film mince conducteur, faisant office de store, puisse alternativement venir couvrir et mettre à découvert l'interface ergonomique du téléphone mobile ; les deux rails de coulissement, le cadre et le film mince étant agencés de façon à assurer une continuité du contact électrique entre les parties conductrices les constituant en partie pour former un tout étanche aux ondes électromagnétiques et globalement concave constituant en partie l'élément de protection, quand le film mince est entièrement déroulé.

Selon une autre particularité du deuxième mode de réalisation, l'écran de protection comprenant le film mince comprend un élément de forme creusée et partiellement complémentaire du pouce de l'utilisateur fixé au film mince pour faciliter à l'utilisateur la manipulation du film mince, faisant office de store, et pour jouer le rôle de butée pour empêcher que le film mince disparaisse totalement dans le magasin du mécanisme de store.

Selon une autre particularité du deuxième mode de réalisation, le cadre de protection est surmonté d'un cadre plan en matériau isolant de dimension et de forme adaptées pour être monté solidaire au cadre de protection entre l'écran de protection et l'utilisateur pour protéger le mécanisme de store et l'écran de protection, faisant office de store, sans pour autant occulter la vue à travers l'élément de protection de l'interface ergonomique du téléphone mobile, et pour que le film mince entièrement enroulé et bloqué par l'élément creusé butant contre l'intérieur du pourtour du cadre plan, reste en partie engagé dans et entre les rails de coulissement.

D'autres particularités et avantages de la présente invention apparaîtront plus clairement à la lecture de la description ci-après, faite en référence aux dessins annexés, dans lesquels :
- la figure 1A représente une vue en perspective du premier mode de réalisation du dispositif, et plus précisément l'élément de protection amovible du téléphone mobile dont l'écran de protection plan est réalisé par un réseau maillé métallique intercalé dans une grille de trame plus fine non métallique,
- la figure 1B représente une vue en perspective du premier mode de réalisation du dispositif et le sens de fixation correct de cette réalisation du dispositif sur un téléphone mobile ; l'écran de protection venant recouvrir l'interface ergonomique du téléphone mobile,
- les figures 1C à 1E représentent schématiquement une variante du premier mode de réalisation dans laquelle l'élément de protection est monté articulé sur un réceptacle en matériau plastique par un mécanisme de clapet et se trouve dans une première de ces deux positions stables: la figure 1C montre une vue en coupe du profil de cette variante, la figure 1D montre une vue de face de cette variante sans l'élément de protection et le figure 1E montre le profil de cette variante,
- la figure 1F se rapporte à la variante du premier mode de réalisation et représente schématiquement l'élément de protection dans la deuxième de ces deux positions stables ; l'élément de protection étant relevé pour permettre à l'utilisateur d'accéder à l'interface ergonomique de son téléphone mobile,
- les figures 2A et 2B représentent schématiquement respectivement une vue de face et une vue en perspective du réseau maillé métallique et ses cotes,
- les figures 3A et 3B représentent une vue en perspective de différents éléments éclatés constituant le deuxième mode de réalisation du dispositif,
- les figures 4A et 4B représentent une vue en perspective du film mince déroulé devant l'interface ergonomique du téléphone mobile, le glissement du film mince étant guidé par les rails de coulissement et des lèvres conductrices étant disposées pour assurer la continuité du contact conducteur d'électricité entre le film mince et la partie métallique des rails de coulissement,
- la figure 5 représente une vue en perspective proposant un grossissement sur le magasin du mécanisme de store situé dans le pourtour du cadre (non représenté) proche du haut-parleur du téléphone mobile dans une variante du deuxième mode de réalisation du dispositif,
- la figure 6 représente une vue en perspective du deuxième mode de réalisation du dispositif entièrement monté et disposé, amovible par des organes de fixation par clipsage, sur l'interface ergonomique du téléphone mobile, le film mince étant entièrement déroulé,
- la figure 7 représente une vue en perspective de différents éléments éclatés constituant en partie un troisième mode de réalisation du dispositif,
- les figures 8A et 8B représentent une vue en perspective de différents éléments montés constituant en partie le troisième mode de réalisation du dispositif,
- les figures 9A et 9B représentent une vue en perspective du troisième mode de réalisation du dispositif, le module recouvrant entièrement l'étui,
- les figures 10A et 10B représentent une vue en coupe des éléments représentés sur les figures 8B et 9B respectivement, selon le troisième mode de réalisation du dispositif,
- les figures 11A et 11B représentent une vue en perspective du module fermé sur l'étui, de face et de dos respectivement, selon le troisième mode de réalisation du dispositif, le module étant maintenu par des languettes repliées au dos de l'étui,
- les figures 12A, 12B, et 12C représentent une vue en perspective du module ouvert et solidaire de l'étui, de ¾ face, de dos et de ¾ dos respectivement, selon le troisième mode de réalisation du dispositif, des velcros étant disposés au dos de l'étui de façon à se trouver en vis à vis des languettes lorsque le module est fermé,
- la figure 13 illustre schématiquement le banc de test situé dans une chambre anéchoïque et réalisé pour les mesures,
- la figure 14 représente un graphe des mesures de transmission en fonction de l'angle d'un mât rotatif pour les divers matériaux constituant en partie l'élément de protection, et
- les figures 15 à 17 représentent un mode de réalisation de l'invention dans lequel l'organe de fixation du téléphone mobile dans la profondeur de l'élément de protection présente deux barres de fermeture situées en vis-à-vis de l'écran de protection par rapport au cadre de protection, et illustrent plus particulièrement la façon dont le téléphone mobile est inséré dans, ou retiré depuis, l'élément de protection.

La description du dispositif et de ses trois modes de réalisation va maintenant être effectuée en liaison avec les figures.

La présente invention propose un dispositif constitué d'au moins un élément de protection (1) de l'utilisateur contre les ondes électromagnétiques émises par un téléphone mobile (2), appareil qui nous est à tous bien connu dans ses formes, ses fonctionnalités et ses usages. Ses émissions continues et puissantes d'ondes électromagnétiques atteignent leur pleine puissance durant une communication téléphonique. C'est donc pendant cette phase d'utilisation particulière que le téléphone est le plus potentiellement nocif, or c'est également pendant cette phase d'utilisation que le téléphone se situe à proximité voire contre la tête de l'utilisateur dans la zone s'étendant de la bouche à une des oreilles. Par conséquent, c'est pendant cette phase de communication qu'il est d'autant plus important de protéger l'utilisateur.

Ce constat simple, lié au mode d'utilisation d'un téléphone mobile, nous permet d'illustrer pourquoi il est nécessaire que l'élément de protection (1) soit agencé de façon à être situé durant une communication sans fil entre le téléphone mobile (2) et son utilisateur. Pour faciliter la compréhension de la présente description, nous profitons de ce que l'élément de protection (1) est de géométrie sensiblement plane pour définir deux demi-espaces de part et d'autre du plan défini par l'élément de protection (1), et nous situons le téléphone mobile (2) dans le demi-espace de droite, et l'utilisateur dans le demi-espace de gauche.

L'élément de protection (1) doit constituer pour l'utilisateur un blindage contre les ondes électromagnétiques émises par son téléphone mobile. Cette caractéristique d'étanchéité aux ondes électromagnétiques ne peut être remplie que par un matériau bon conducteur, tel que le cuivre. C'est pourquoi l'élément de protection (1) doit être réalisé au moins en partie en un tel matériau.

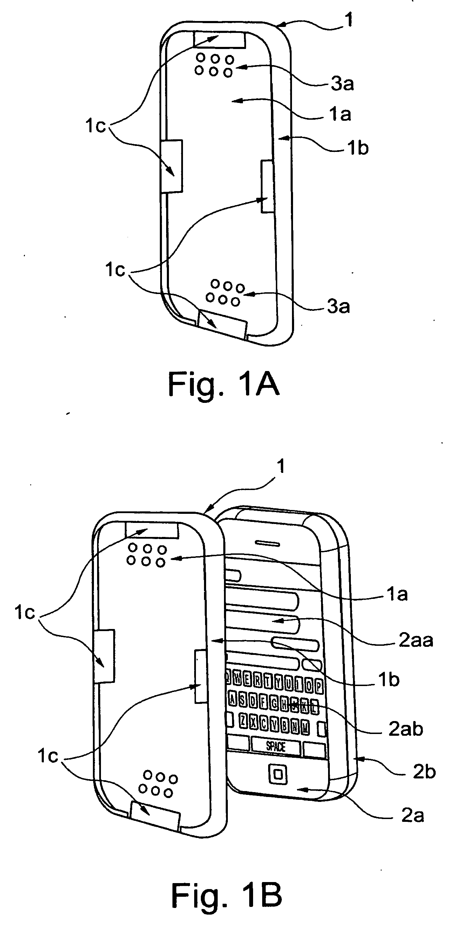

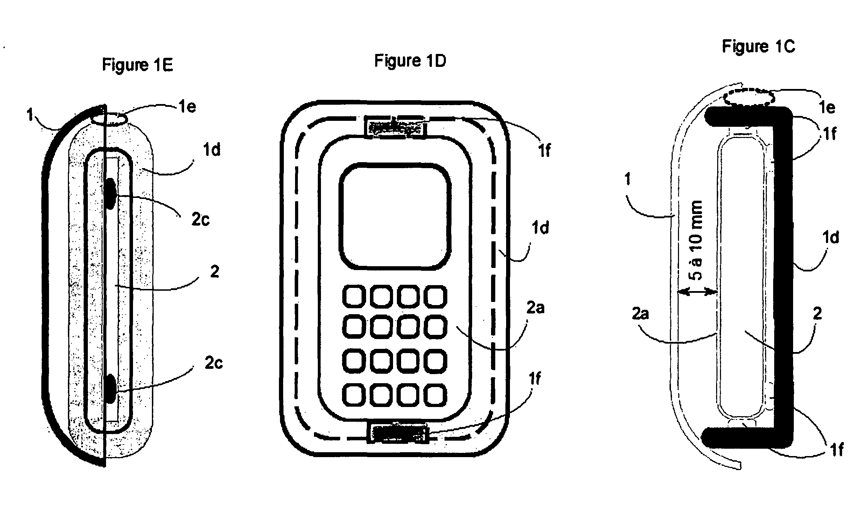

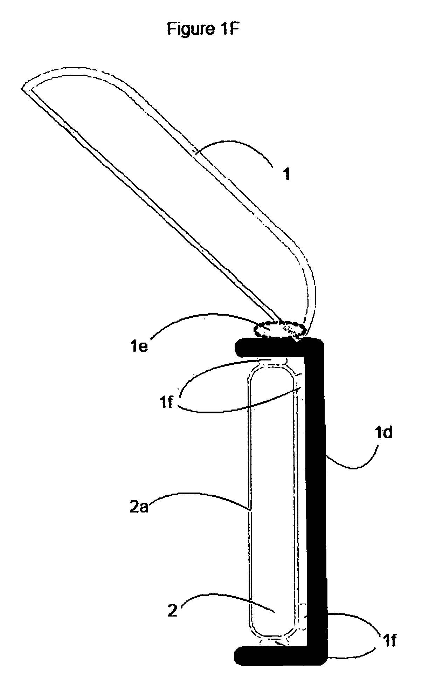

Si de plus, l'élément de protection (1) est concave (cf. figures 1A, 1C,1E et 1F) et que sa concavité est orientée vers le demi-espace de droite (cf. figure 1 B), alors les ondes électromagnétiques émises par le téléphone mobile (2) sont non seulement réfléchies par l'élément de protection (1) dans tout le demi-espace de droite, mais aussi émises dans le demi-espace de droite préférentiellement selon une direction normale au plan défini par l'élément de protection (1), c'est-à-dire dans la direction opposée à l'utilisateur. Cette forme concave rend donc l'élément de protection (1) plus efficace que s'il formait une simple surface plane finie.

Toutefois, il est à noter que l'objectif de protection du dispositif de la présente invention ne peut être atteint qu'à certaines conditions dont au moins deux sont primordiales.
Premièrement, la concavité de l'élément de protection (1) doit être suffisamment ouverte et/ou suffisamment profonde pour éviter le retour des ondes électromagnétiques dans le demi-espace de gauche par des effets de bords le long du pourtour de l'élément de protection (1). C'est pourquoi la section curviligne du cadre (1 b) de protection doit avoir un rayon de courbure supérieure à la profondeur de l'élément de protection (1) et/ou la profondeur de l'élément de protection doit être supérieure à l'épaisseur du téléphone mobile, la combinaison de ces deux caractéristiques étant envisageable à moins qu'elles ne soient incompatibles entre elles. De plus, et pour la même raison, l'élément de protection (1) doit se trouver en vis-à-vis d'au moins le tiers de l'épaisseur du pourtour (2b) du téléphone mobile (2). En conséquence, la dimension en profondeur de l'élément de protection (1) doit être supérieure au tiers de l'épaisseur du pourtour (2b) du téléphone mobile (2) (cf. figures 1C et 1E).
Deuxièmement, l'élément de protection (1) est constitué au moins en partie en matériau métallique bon conducteur, comme le sont les antennes émettrices/réceptrices d'ondes électromagnétiques, or il faut s'assurer que l'élément de protection (1) ne fonctionne pas pour l'utilisateur comme une antenne mais bel et bien comme une protection. Pour cela, il ne faut pas que l'élément de protection (1) capte et amplifie les rayonnements électromagnétiques émis par le téléphone mobile (2). C'est pourquoi, il est nécessaire d'isoler électriquement le téléphone mobile (2) de l'élément de protection (1), ou plus particulièrement de la partie en matériau métallique bon conducteur de l'élément de protection. Cette isolation électrique est réalisée et assurée en maintenant un espace d'au moins 2 mm (cf. figure 1 C), de toute part, entre le téléphone mobile (2) et la partie métallique de l'élément de protection (1). **Il** est à noter que, pour un espace par exemple de 0,5 mm entre l'interface ergonomique du téléphone mobile et la partie métallique de l'élément de protection, la partie métallique de l'élément de protection conduit, voire amplifie, les ondes électromagnétiques émises et/ou reçues par le téléphone mobile. On peut également préciser une borne supérieure des valeurs possibles pour l'espace électriquement isolant entre l'interface ergonomique du téléphone mobile (2) et la partie métallique de l'élément de protection (1). Cette borne supérieure est fixée à 10 mm. Ce choix est uniquement dicté par le souhait de conserver un ensemble, formé du téléphone mobile et de son élément de protection, qui soit mobile et d'une taille et d'un esthétisme convenables. Préférentiellement, l'espace électriquement isolant entre le téléphone mobile (2) et la partie métallique de l'élément de protection (1) est, de toute part, d'une valeur comprise entre 3 mm et 8 mm.
En conséquence, les dimensions en longueur et en largeur de l'élément de protection (1) doivent être supérieures aux dimensions en longueur et en largeur du téléphone mobile (2). En conséquence également, la dimension en profondeur de l'élément de protection (1) doit être au moins égale au tiers de l'épaisseur du pourtour (2b) du téléphone mobile (2) additionnée de l'espace électriquement isolant entre l'interface ergonomique du téléphone mobile et la partie métallique de l'élément de protection situé en vis-à-vis de ladite interface ergonomique (cf. figures 1C et 1E).

Dans le cas d'une métallisation pouvant être continue ou discontinue, sur un substrat électriquement isolant d'une épaisseur déterminée, l'espace électriquement isolant entre l'interface ergonomique du téléphone mobile et la partie métallique de l'élément de protection correspond à l'espace entre l'interface ergonomique du téléphone mobile et le substrat, plus l'épaisseur déterminée du substrat.

Le choix d'un élément de protection plus ou moins ouvert et/ou plus ou moins profond et le choix d'un espace électriquement isolant entre l'interface ergonomique du téléphone mobile (2) et la partie métallique de l'élément de protection (1) d'une valeur particulière d'au moins 2 mm, sont préférentiellement dépendants l'un de l'autre. De nombreux tests scientifiques de performance de protection de l'élément de protection selon l'invention ont été effectués. Il en ressort que les deux conditions primordiales ci-dessus énoncées sont liées entre elles relativement aux capacités fonctionnelles de base d'émission/réception du téléphone mobile. Premièrement, pour un téléphone mobile (2) et un élément de protection (1) de forme et de dimensions fixées, il peut résulter d'un espace faible entre eux, par exemple inférieur à 2 mm, un disfonctionnement et/ou une perte de performance significative du téléphone mobile quant à ces capacités fonctionnelles de base d'émission/réception. Cet inconvénient est largement estompé dès lors que ledit espace électriquement isolant atteint une valeur d'au moins 3 mm.
Deuxièmement, pour un même espace électriquement isolant entre le téléphone mobile et la partie métallique de l'élément de protection, plus l'élément de protection est profond relativement à l'épaisseur du téléphone mobile, plus le disfonctionnement et la perte de performance du téléphone mobile sont significatifs. Du fait que le téléphone délivre des signaux d'une plus grande puissance afin de conserver la qualité des transmissions, une surchauffe et/ou un déchargement prématuré de sa batterie, ou plus généralement une réduction de son autonomie, peuvent alors être observés. La qualité de la protection contre les ondes électromagnétiques émises par le téléphone mobile est, quant à elle, faiblement affectée par la variation de ces paramètres et reste satisfaisante dans les limites définies dans la présente demande.

Le choix d'un élément de protection suffisamment ouvert et/ou suffisamment profond et le choix d'une valeur d'au moins 2 mm, préférentiellement comprise entre 3 mm et 8 mm, pour l'espace électriquement isolant entre l'interface ergonomique du téléphone mobile et la partie métallique de l'élément de protection doit donc correspondre à la recherche d'un compromis entre la qualité de la protection apportée et la qualité des communications téléphoniques. De plus, le souhait de conserver un ensemble, téléphone mobile et élément de protection, qui est mobile et esthétique impose un encombrement minimum. C'est à cette fin qu'il est précisé un espace électriquement isolant de 10 mm maximum, préférentiellement de 8 mm maximum.

Les fourchettes de valeurs suivantes sont précisées et données à titre d'exemple non limitatif. La longueur de l'élément de protection est égale ou supérieure à 1,15 fois la longueur du téléphone mobile, la largeur de l'élément de protection est égale ou supérieure à 1,2 fois la largeur du téléphone mobile, et la profondeur de l'élément de protection est égale ou supérieure à 1,3 fois l'épaisseur du téléphone mobile. La longueur de l'élément de protection est inférieure ou égale à 1,3 fois la longueur du téléphone mobile, la largeur de l'élément de protection est inférieure ou égale à 1,3 fois la largeur du téléphone mobile et la profondeur de l'élément de protection est inférieure ou égale à 1,6 fois l'épaisseur du téléphone mobile. Les dimensions de l'élément de protection relativement aux dimensions du téléphone mobile sont à définir au cas par cas dans les fourchettes de valeurs mentionnées, afin d'optimiser la protection apportée, tout en minimisant l'encombrement de l'élément de protection et la relative dégradation des performances du téléphone mobile liée à son utilisation avec l'élément de protection.

Du fait de son étanchéité aux ondes électromagnétiques, l'élément de protection (1) ne doit pas recouvrir entièrement le téléphone mobile (2) car cela rendrait impossible tout protocole de communication nécessitant l'émission, et/ou la réception, par le téléphone mobile d'ondes électromagnétiques vers, et/ou de, l'extérieur, respectivement. C'est pourquoi l'élément de protection (1) est ouvert, le fond de la concavité étant disposé en vis-à-vis de l'interface ergonomique du téléphone mobile (cf. figures 1C et 1E).

Cette caractéristique de l'élément de protection (1) rend sa conception plus facile et son adaptation plus large. En effet, ne formant pas une boîte fermée, mais un réceptacle ouvert, l'élément de protection (1) est contraint en dimension et en forme par les dimensions et la forme de la face du téléphone mobile (2) comprenant l'interface ergonomique (2a) et les dimensions et la forme du pourtour de l'épaisseur (2b) du téléphone mobile (2), mais n'est pas contraint par les dimensions ou la forme de la face du téléphone mobile (2) opposée à l'interface ergonomique (2a).

Dans les trois modes de réalisation du dispositif de protection selon l'invention, l'élément de protection apparaît comme un parallélépipède rectangle ouvert sur une de ses bases pour former un réceptacle globalement concave et courbé. Les coins et les arrêtes dudit parallélépipède rectangle sont préférentiellement non saillants, mais arrondis ou biseautés. Cette particularité est introduite afin de fournir un dispositif de protection qui soit esthétique, mais également afin d'assurer et augmenter l'aspect concave de l'élément de protection, et par conséquent la qualité de la protection apportée. Ainsi, l'homme de métier comprendra qu'il importe peu par exemple que la partie non métallisée du dispositif de protection ait des angles arrondis ou biseautés, mais qu'il importe que la partie métallisée en ait. Par exemple, dans le cas d'une métallisation de l'élément de protection sur la surface externe d'un substrat en matériau isolant de la forme d'un parallélépipède rectangle, il importe peu que les angles et les arrêtes intérieurs du parallélépipède soient arrondis ou biseautés, ceux-ci étant constitués en matériau isolant et ne présentant donc pas de propriété de blindage aux ondes électromagnétiques. Au contraire, il importe que les angles et arrêtes extérieurs du parallélépipède soient arrondis ou biseautés, car ceux-ci constituent ou supportent la métallisation de la surface externe du parallélépipède qui présente une propriété de blindage aux ondes électromagnétiques.

Dans les trois modes de réalisation du dispositif de la présente invention, la fixation ou l'insertion du téléphone mobile (2) dans l'élément de protection (1) est de la responsabilité de l'utilisateur. Si l'élément de protection (1) recouvre la face opposée à l'interface ergonomique (2a) de sorte que la concavité de l'élément de protection (1) soit orientée vers l'utilisateur, l'élément de protection (1) augmente pour l'utilisateur le débit d'absorption spécifique (DAS). En effet, les ondes électromagnétiques émises par le téléphone mobile (2) convergent alors vers l'utilisateur augmentant ainsi son exposition par rapport à un usage du téléphone mobile (2) sans élément de protection (1). Pour pallier cette éventualité et prévenir tout risque pour l'utilisateur, la présente invention propose que chaque mode de réalisation du dispositif présente des caractéristiques d'agencement fonctionnant à la façon d'un détrompeur, empêchant l'utilisateur de fixer l'élément de protection (1) sur le téléphone mobile de telle sorte que l'écran de protection se trouve en vis-à-vis de la face opposée à l'interface ergonomique (2a).

Dans les trois modes de réalisation du dispositif, l'élément de protection (1) peut comporter un ou plusieurs orifices (3a) (cf. figure 1A) de taille caractéristique inférieure aux différentes longueurs d'onde des ondes électromagnétiques des différentes normes de téléphonie mobile, par exemple inférieure à 1 cm. Imposer une limite supérieure à la taille caractéristique des orifices (3a) assure que ceux-ci n'altèrent pas la qualité de la protection aux ondes électromagnétiques apportée par l'élément de protection (1) selon l'invention. Par exemple, à une onde électromagnétique de fréquence 30 GHz est associée une longueur d'onde de 1 cm, or les téléphones mobiles émettent des ondes électromagnétiques d'une fréquence d'environ 1 GHz correspondant à une longueur d'onde de 30 cm environ. Des orifices (3a) sont par exemple situés en vis-à-vis du haut-parleur et/ou du microphone du téléphone mobile (2) et/ou plus généralement de tout dispositif du téléphone mobile (2) émettant ou recevant des ondes acoustiques, pour prévenir et éviter toute altération de la qualité de la transmission des ondes acoustiques entre l'utilisateur et le téléphone mobile (2). En outre, des orifices sont par exemple situés en face des connectiques du téléphone mobile, pour en autoriser l'accès.

De façon générale, l'idée présentée dans les différents modes de réalisation est de permettre à l'utilisateur de se protéger des ondes électromagnétiques émises par son téléphone mobile (2) quand il le souhaite.

Les figures 1A à 2B illustrent le premier mode de réalisation du dispositif de l'invention qui va être discuté ci-après.

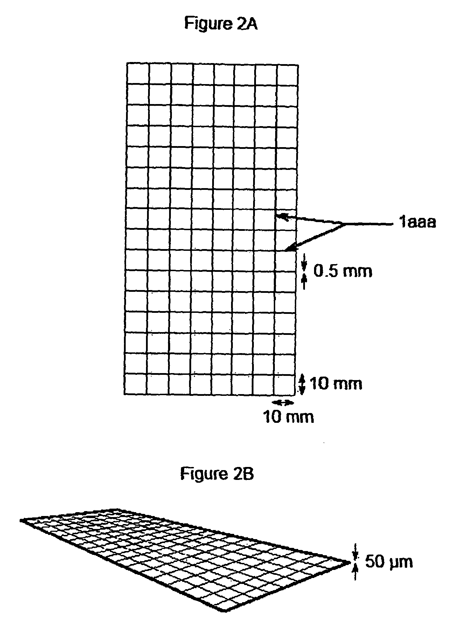

La figure 1A montre l'élément de protection (1) dans le premier mode de réalisation du dispositif. L'élément de protection (1) y apparaît comme un réceptacle ouvert globalement concave, approximativement de la forme d'un parallélépipède rectangle. N'étant pas réalisé de façon homogène, il est utile de décomposer l'élément de protection (1) en ses deux parties homogènes : l'écran (1a) formant approximativement la base du parallélépipède rectangle et le cadre (1 b) formant approximativement le pourtour de l'épaisseur du parallélépipède rectangle.
Dans le premier mode de réalisation et comme illustré sur les figures 2A et 2B, l'écran (1a) est composé en partie d'un réseau maillé métallique (1aa) bon conducteur. Ce réseau maillé métallique (1aa) a un pas de grille régulier de 10 mm sur 10 mm et ses lignes conductrices (1aaa) ont une largeur de 0,5 mm. Un tel réseau maillé métallique (1aa) constitue un blindage contre les ondes électromagnétiques de fréquences inférieures à 3 GHz, or les ondes électromagnétiques émises par les téléphones mobiles sont d'environ 1 GHz, ce qui correspond à une longueur d'onde λ de 30 cm ; des ouvertures de l'ordre de λ/30 sont permises sans altérer les effets de protection recherchés. Par conséquent, ce mode de réalisation de l'écran (1a) de l'élément de protection (1) constitue un blindage plus qu'efficace sur une bande de fréquence des ondes électromagnétiques plus large que celle utilisée par la plupart des téléphones mobiles actuellement sur le marché.

Ce réseau maillé métallique (1aa) est toutefois fragile et l'invention propose pour assurer la longévité de cette protection de l'incorporer dans, ou de l'imprimer par sérigraphie sur, un support plus robuste comme une membrane ou de l'intercaler dans une grille de trame plus fine.

L'écran (1a) ainsi constitué est monté solidaire et tendu sur un cadre (1b) (cf. figure 1A) comprenant au moins une partie en matériau métallique bon conducteur à sa surface ou dans son épaisseur de façon à ce que la partie métallique de l'écran (1a) soit en contact conducteur d'électricité avec la partie métallique du cadre (1b) ou soit espacée de moins de 5 mm de la partie métallique du cadre pour former un élément de protection (1) d'un seul tenant et globalement concave entièrement étanche aux ondes électromagnétiques.

Il est à noter ici que, dans tous les modes de réalisation présentés, la continuité électrique entre le cadre de protection et l'écran de protection est préférée assurée. Toutefois, du fait que les téléphones mobiles émettent des ondes électromagnétiques d'une fréquence d'environ 1 GHz correspondant à une longueur d'onde de 30 cm environ, des discontinuités physiques en certains endroits, par exemple des trous de l'ordre de 1 cm, sont envisageables tout en conservant la continuité électrique entre le cadre et l'écran et sans altérer la qualité de la protection apportée par le dispositif selon l'invention. De même, une discontinuité électrique entre la partie métallique du cadre et la partie métallique de l'écran est envisageable si elle est réalisée par une discontinuité physique entre la partie métallique du cadre et la partie métallique de l'écran qui est d'une taille caractéristique inférieure, par exemple d'au moins un facteur 10, aux différentes longueurs d'onde des ondes électromagnétiques des différentes normes de téléphonie mobile, préférentiellement inférieure à 5 mm.

Comme illustré sur les figures 1B, 1C et 1E, l'élément de protection (1) selon le premier mode de réalisation se trouve en vis-à-vis de l'interface ergonomique (2a) du téléphone mobile et en vis-à-vis d'au moins une partie de l'épaisseur du pourtour du téléphone mobile (2). Il doit toutefois permettre à l'utilisateur de voir l'interface ergonomique (2a) constituée d'un écran (2aa) associé à un clavier (2ab) physique ou virtuel (cf. figure 1 B). C'est pourquoi, selon l'invention, le réseau métallique (1aa) a une épaisseur de 50 µm seulement et le support du réseau maillé métallique doit être transparent dans le domaine du visible.

Pour augmenter l'efficacité de l'élément de protection selon le premier mode de réalisation, il est envisageable que la forme de l'écran (1 a) s'éloigne légèrement de celle d'un plan pour prendre une forme légèrement concave dont la concavité est évidemment orientée dans le même sens que la concavité de l'élément de protection.

Dans ce premier mode de réalisation, l'élément de protection (1) est amovible du téléphone mobile (2) et est fixé par au moins un organe (1c) de fixation par clipsage, fixé sur le pourtour intérieur du cadre de protection (1b) et réalisé en matériau isolant de sorte qu'un espace isolant électriquement d'une épaisseur d'au moins 2 mm soit maintenu, de toute part, entre le téléphone mobile (2) et la partie métallique de l'élément de protection (1).

Dans une variante du premier mode de réalisation schématiquement illustré sur les figures 1C à 1F, l'élément de protection (1) est monté articulé par un mécanisme de clapet (1e) sur un réceptacle (1d) ouvert, réalisé en matériau plastique non conducteur, de forme et dimensions adaptées pour former un logement pour le téléphone mobile (2) ; le téléphone mobile (2) étant maintenu dans son réceptacle (1d) par un matériau isolant, par exemple de la mousse adhésive (1f), appliqué en plusieurs points de contact entre le téléphone mobile (2) et le réceptacle (1d), l'interface ergonomique (2a) du téléphone mobile étant orientée vers le côté ouvert du réceptacle (1d) (cf. plus particulièrement la figure 1 D).

Cette variante du premier mode de réalisation présente plusieurs avantages.
Premièrement, le mécanisme à clapet est peu onéreux. Il est réalisé, par exemple, grâce à un ressort à lame.
Deuxièmement, il permet à l'élément de protection (1) de prendre deux positions stables situées aux deux extrémités de son parcours de rotation autour de l'axe défini par le mécanisme de clapet (1e), par exemple situé sur le pourtour du réceptacle (1d) le plus proche du haut-parleur du téléphone mobile (2).
Comme schématiquement représentée sur la figure 1E, une première position stable correspond à une position de la partie métallique de l'élément de protection en vis-à-vis, et à une distance d'au moins 2 mm (cf. figure 1 C), de l'interface ergonomique (2a) du téléphone mobile (2) ; la concavité de l'élément de protection (1) étant orientée dans un sens opposé à la concavité du réceptacle (1d) et le ressort à lame du mécanisme de clapet (1e) sollicitant en permanence l'élément de protection en butée contre le pourtour du réceptacle (1d). Cette première position de stabilité correspond donc à une position de protection de l'utilisateur pendant une communication. Comme schématiquement représentée sur la figure 1F, une deuxième position stable de l'élément de protection correspond à une position dans laquelle l'élément de protection est relevé au dessus du téléphone mobile (2) et forme un angle avec le téléphone mobile (2) adhérant au réceptacle (1 d) de l'ordre de 140° à 170°, suffisant pour permettre à l'utilisateur d'accéder à l'interface ergonomique de son téléphone mobile (2) sans être gêné par l'élément de protection (1). Cette seconde position permet à l'utilisateur d'accéder aux fonctionnalités du téléphone mobile (2) prévues par le constructeur via l'interface ergonomique (2a).
Entre ces deux positions stables, l'élément de protection (1) se trouve en position instable et, sous la sollicitation du ressort à lame du mécanisme de clapet (1e) et suivant l'angle qu'il forme avec le téléphone mobile, il bascule dans l'une ou l'autre de ces deux positions stables.
Ainsi, l'utilisateur peut relever l'élément de protection dans sa deuxième position de stabilité le temps, par exemple, de composer un numéro d'appel ou de répondre à un appel entrant, puis, par une simple manipulation consistant à faire tourner l'écran de protection (1) de quelques dizaines de degrés autour de son axe de rotation vers l'interface ergonomique de façon à ce que celui-ci bascule dans sa position de protection, l'utilisateur peut alors communiquer en étant protégé par son élément de protection (1) des ondes électromagnétiques émises par son téléphone mobile (2).
Troisièmement, comme dans les autres modes de réalisation, cette variante du premier mode de réalisation est munie d'un détrompeur, en ce sens que le fond du réceptacle (1 d) est opaque. Or l'utilisateur désirant se protéger sans se priver des fonctionnalités de son téléphone mobile (2), et particulièrement celles accessibles via l'interface ergonomique (2a), ne peut pas disposer le téléphone mobile (2) en orientant son interface ergonomique (2a) vers le fond du réceptacle (1 d) opaque.
Quatrièmement, comme illustré schématiquement sur la figure 1E, le pourtour du réceptacle (1d) est par exemple évidé en partie pour permettre à l'utilisateur d'accéder aux connectiques (2c) du téléphone mobile, et ce, au moins quand l'élément de protection est relevé.

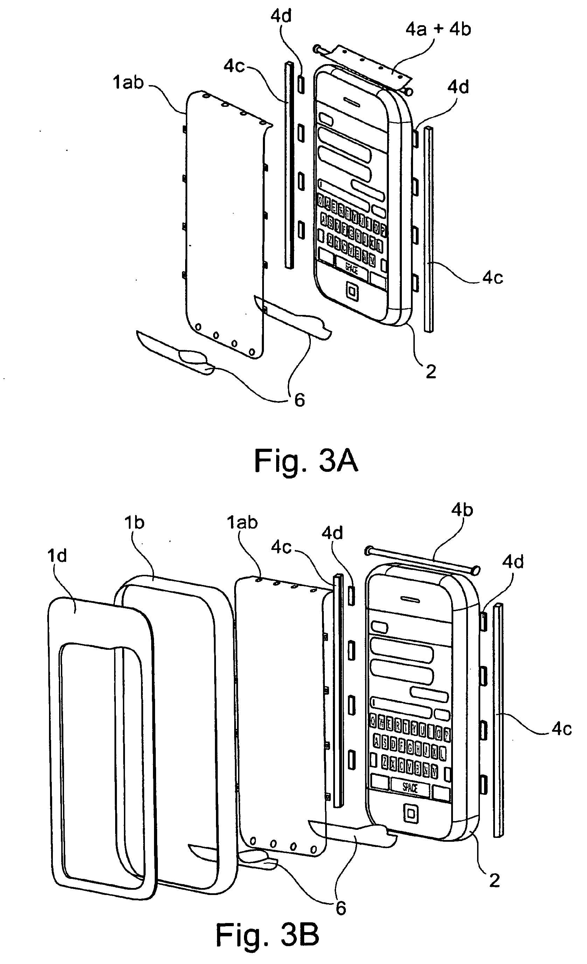

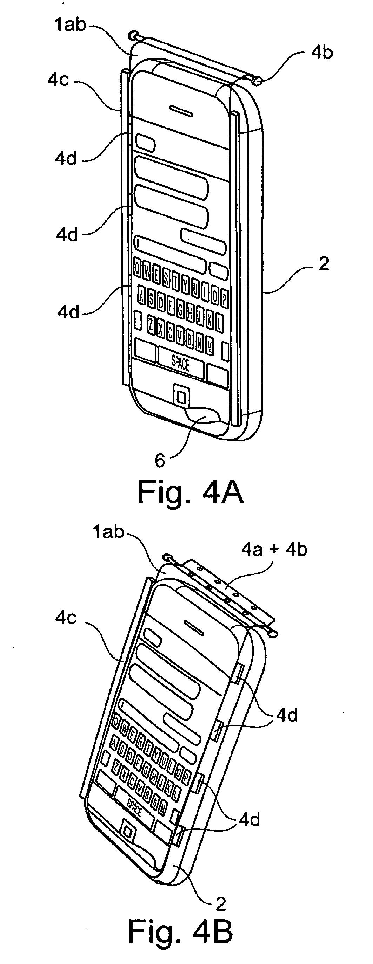

Les figures 3A à 6 illustrent schématiquement le deuxième mode de réalisation du dispositif.

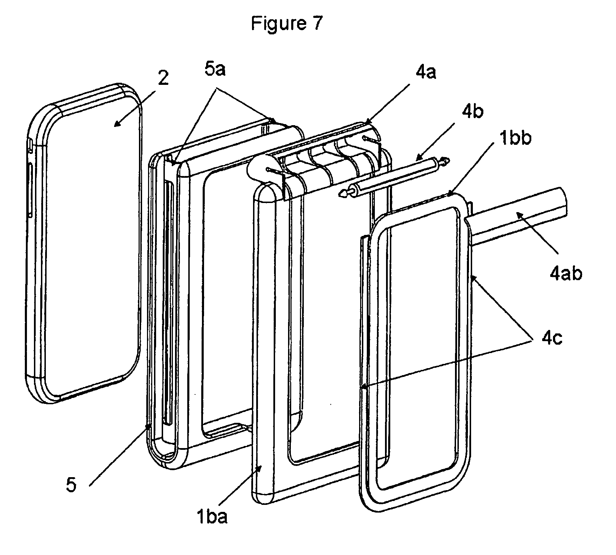

Les figures 7 à 12C illustrent schématiquement le troisième mode de réalisation du dispositif.

Selon les deuxième et troisième modes de réalisation du dispositif et comme illustré sur les figures 3A, 3B, 4A, 4B et 5, l'élément de protection (1) est constitué d'au moins un film mince (1ab), consistant en une métallisation, pouvant être continue ou discontinue, de sa surface, ladite métallisation étant déposée sur, ou incorporée dans, une membrane réalisée en matériau souple pour que le film mince (1ab) ainsi formé soit suffisamment souple pour être enroulable sur lui-même, l'élément de protection étant en outre constitué d'un cadre (1b) de protection. Ces deux parties de l'élément de protection (1) sont fonctionnellement combinées à un mécanisme de store (4) comprenant un magasin (4a) muni d'un enrouleur-dérouleur (4b) et de deux rails de coulissement (4c) équipés de lèvres conductrices (4d) ; le film mince (1ab) faisant office de store et étant par exemple associé à un ressort à spirale (non représenté) permettant de commander l'enroulement du film mince (1 ab).

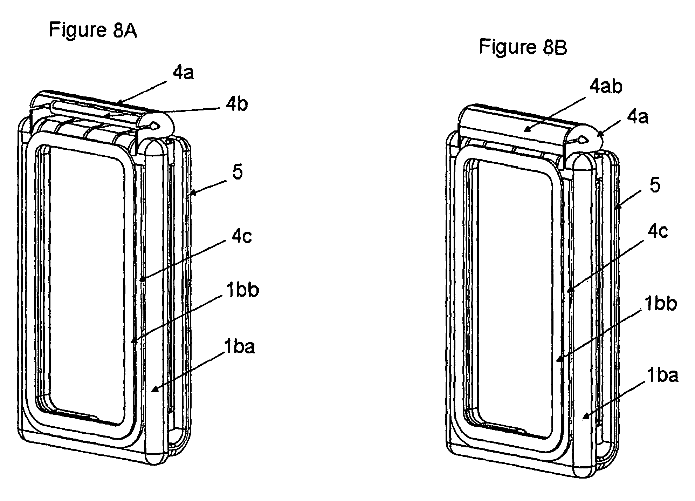

Le magasin (4a) du mécanisme de store est incorporé dans, ou disposé sur, un des quatre côtés du pourtour du cadre (1 b) de l'élément de protection (1). Dans l'exemple illustré sur les figures 3B, 4A, 4B et 5, le magasin (4a) du mécanisme de store est incorporé dans la partie du pourtour du cadre (1 b) de l'élément de protection (1) qui se trouve au plus près du haut-parleur du téléphone mobile (2). Dans l'exemple illustré sur les figures 7, 8A et 8B, le magasin (4a) du mécanisme de store est disposé sur la partie du pourtour du cadre (1 b) de l'élément de protection (1) qui se trouve au plus prés du haut-parleur du téléphone mobile (2). Dans les deux cas, le magasin (4a) du mécanisme de store est prévu pour permettre d'y loger le film mince (1 ab) faisant office de store enroulé autour de l'enrouleur-dérouleur (4b) situé approximativement au milieu du magasin (4a) dans le plan de glissement du store ; le plan de glissement du store étant défini comme un plan parallèle à, et distant d'au moins 2 mm de, l'interface ergonomique (2a).

Dans le deuxième mode de réalisation, le cadre (1b) est constitué d'un seul tenant comme dans le premier mode de réalisation du dispositif. Mais dans le troisième mode de réalisation (cf. figure 7), le cadre (1b) comprend deux parties, chacune réalisée au moins en partie en matériau bon conducteur, la première prenant la forme du cadre (1ba) tel que précédemment défini et la deuxième prenant la forme d'un cadre (1bb) de section plane et de dimensions en longueur et en largeur légèrement inférieures aux dimensions en longueur et en largeur du cadre (1ba).

Les rails de coulissement (4c) se situent dans le plan de glissement du store et sont fixés en contact conducteur d'électricité au moins à une partie métallique du cadre (1b) de protection. Dans le deuxième mode de réalisation et comme illustré sur la figure 3B, les rails de coulissement (4c) sont fixés à l'intérieur et dans l'épaisseur du pourtour du cadre (1b). Dans le troisième mode de réalisation et comme illustré sur la figure 7, les rails de coulissement (4c) sont fixés au cadre (1 bb) de section plane.

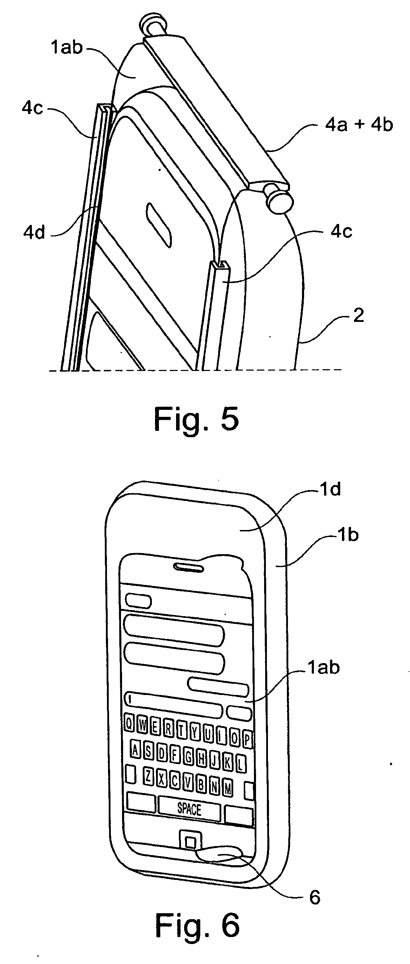

Dans le deuxième et troisième mode de réalisation et comme illustré à la figure 5, des lèvres conductrices (4d) sont disposées régulièrement espacées et fixées en contact conducteur d'électricité dans chaque rail de coulissement (4c), de façon à ce que le film mince (1ab) faisant office de store soit pincé entre les lèvres conductrices (4d) et une des deux jambes du rail de coulissement (4c) pour assurer un contact conducteur d'électricité entre le film mince (1 ab) et chaque rail de coulissement (4c).

Dans le deuxième et troisième mode de réalisation (cf. figures 6, 9B et 11A), un élément (6) de forme creusée et partiellement complémentaire du pouce est fixé au film mince (1ab) dans sa largeur pour faciliter à l'utilisateur la manipulation du film mince (1ab), faisant office de store, et pour jouer le rôle de butée pour empêcher que le film mince (1ab) disparaisse totalement dans le magasin (4a) du mécanisme de store.

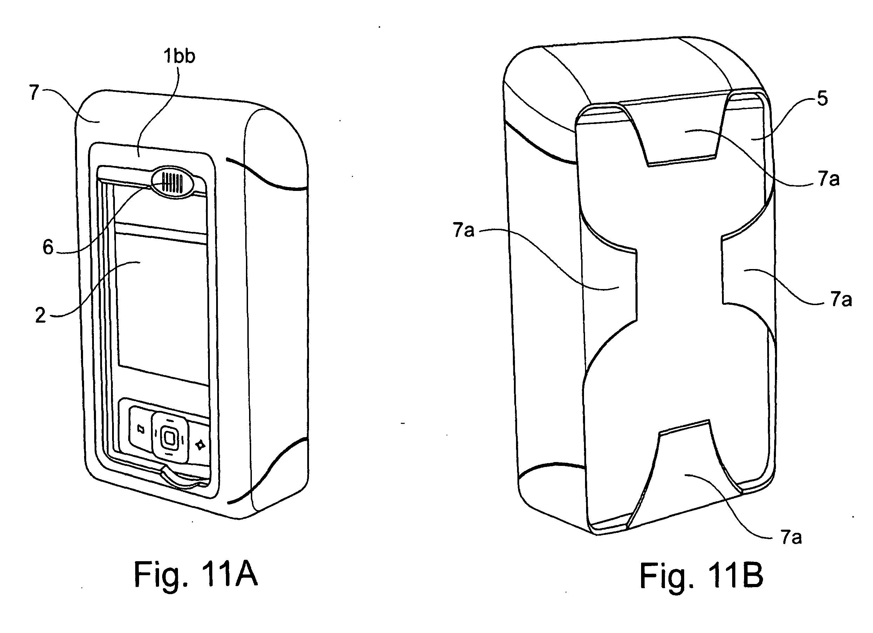

Selon les deuxième et troisième modes de réalisation du dispositif (cf. figures 5 et 11A), le film mince (1ab) est partiellement transparent dans le domaine du visible de façon à ne pas occulter la vue de l'interface ergonomique (2a).

Dans le deuxième mode de réalisation du dispositif et comme illustré sur la figure 6, un cadre (1d) réalisé en matériau isolant rigide, par exemple en plastique, surmonte le cadre de protection (1b), d'une part, de façon à protéger le mécanisme de store et, d'autre part, de façon à ce que le film mince (1ab) entièrement enroulé dans le magasin (4a) du mécanisme de store reste en partie engagé dans et entre les deux rails de coulissement (4c) grâce à l'élément creusé (6) partiellement complémentaire du pouce jouant le rôle de butée contre le cadre (1d).

Dans le deuxième mode de réalisation, l'élément de protection (1) est amovible du téléphone mobile (2) et est fixé par au moins un organe (1c) de fixation par clipsage réalisé en matériau isolant de sorte qu'un espace isolant électriquement d'une épaisseur d'au moins 2 mm soit maintenu, de toute part, entre le téléphone mobile (2) et la partie métallique de l'élément de protection (1).

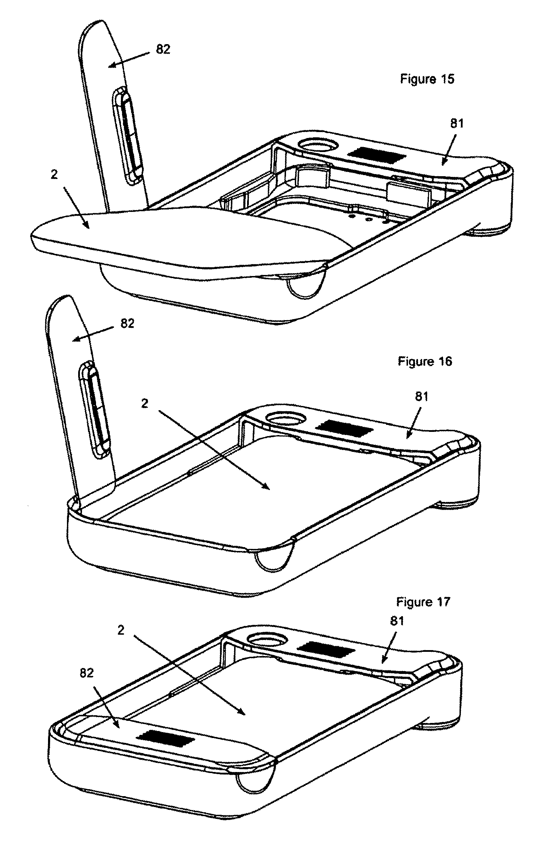

Dans les modes de réalisation illustrés par au moins les figures 1A, 1 B et 3A à 6, l'élément de protection est amovible du téléphone mobile et ce dernier est par exemple maintenu dans la profondeur de l'élément de protection par un organe de fixation réalisé en matériau isolant non conducteur, plastique ou élastomère, qui se compose de deux barres de fermeture. Dans cet exemple illustré sur les figures 15 à 17, les deux barres de fermeture sont montées sur le cadre de protection en vis-à-vis de l'écran de protection par rapport au cadre de protection. Autrement dit, dans cet exemple, les deux barres de fermeture sont situées dans le dos du téléphone mobile lorsque le téléphone mobile est disposé dans la profondeur de l'élément de protection, l'interface ergonomique du téléphone mobile étant disposée en vis-à-vis de l'écran de protection. Par exemple, une des deux barres de fermeture est montée en haut du cadre de protection et l'autre des deux barres de fermeture est montée en bas du cadre de protection. Une des deux barres de fermeture est par exemple fixée, par exemple par clipsage, au cadre de protection. L'autre des deux barres est par exemple articulée sur le pourtour du cadre par exemple par une des ses extrémités, l'autre de ses extrémités pouvant alors mettre en prise le cadre de protection. L'articulation est par exemple une articulation de type pivot et la barre de fermeture articulée pivote autour de l'axe de la liaison pivot à la façon d'un battant. L'articulation est par exemple une articulation du type permettant le glissement sur le côté de la barre de fermeture articulée à la façon d'un coulissant. La mise en prise est assurée par un dispositif de verrouillage/déverrouillage par exemple du type d'un loquet agencé en partie dans ladite extrémité de la barre de fermeture pouvant mettre en prise le cadre de protection et en partie dans le pourtour interne du cadre. L'utilisateur peut ainsi faire pivoter ou coulisser la barre de fermeture articulée depuis une position de fermeture jusqu'à une position d'ouverture pour se faciliter l'insertion du téléphone mobile dans, ou le retrait du téléphone mobile depuis, l'élément de protection.

Dans le troisième mode de réalisation et comme illustré sur les figures 7, 8A et 8B, le mécanisme de store (4) et l'élément de protection (1) sont agencés de façon adaptée à un élément creux (5) de forme et de dimensions devant être adaptées pour former un logement permettant d'y insérer le téléphone mobile (2). L'élément creux (5) est réalisé en matériau électriquement isolant et l'épaisseur de la matière le constituant doit être suffisante pour que la partie métallique de l'élément de protection (1) fixées sur l'élément creux (5) soit maintenue distante de l'interface ergonomique du téléphone mobile (2) par un espace électriquement isolant d'une épaisseur d'au moins 2 mm.

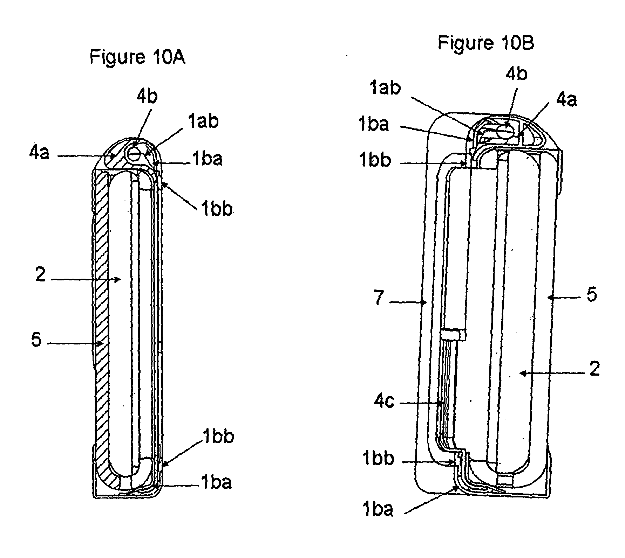

Pour remplir ces objectifs, l'élément creux (5) (cf. figure 7) est approximativement de la forme d'un parallélépipède régulier aux angles arrondis non saillants dont les dimensions en longueur et en largeur sont inférieures aux dimensions en longueur et en largeur de l'élément de protection (1) et supérieures aux dimensions en longueur et en largeur du téléphone mobile (2) et dont la dimension en profondeur est supérieure à l'épaisseur du téléphone mobile (2) (cf. figures 10A et 10B). De plus, la base du parallélépipède sur laquelle est fixée solidaire au moins une partie de l'élément de protection (1) est évidée, la face opposée à la face évidée est pleine et le pourtour de sa profondeur est évidé sur trois de ses côtés. Comme illustré sur les figures 10A et 10B, le quatrième côté étant plein, l'élément creux (5) forme plus particulièrement une structure dont la vue en coupe dans la largeur de l'élément creux (5) est en forme de U, le fond du U étant formé par le côté plein du pourtour de l'élément creux (5) et les jambes du U étant formées par les deux faces opposées de l'élément creux (5).

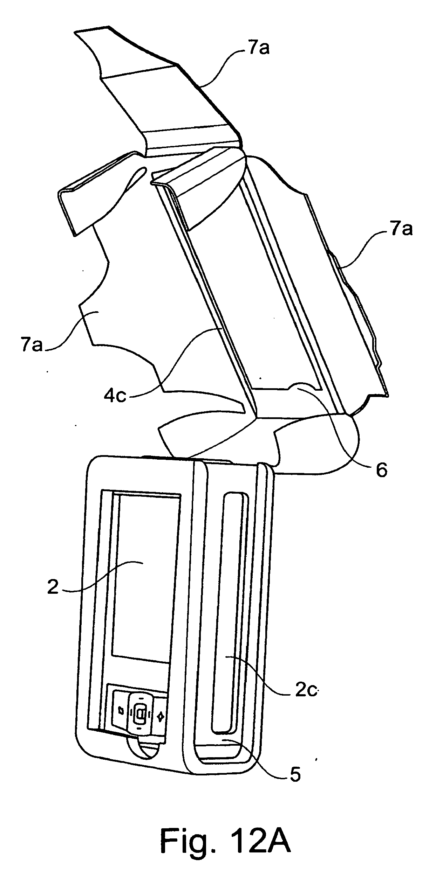

De cette façon et comme illustré sur les figures 11A et 12A, l'interface ergonomique (2a) est orientée vers la jambe du U représentant la face évidée de l'élément creux (5), et, le pourtour du téléphone mobile (2) proche du microphone est orienté vers le fond du U représentant le côté plein du pourtour de l'élément creux (5), ce côté plein du pourtour étant agencé de façon à rendre impossible l'orientation de l'interface ergonomique (2a) vers la jambe du U représentant la face pleine de l'élément creux (5).

Ainsi, l'utilisateur peut voir l'interface ergonomique (2a) à travers la face évidée de l'élément creux (5) et ne peut pas se tromper sur le sens prévu d'insertion du téléphone mobile (2) dans l'élément creux (5).

De plus et comme illustré sur la figure 7, l'élément creux (5) est équipé de deux glissières (5a) évidées disposées en vis-à-vis entre les faces opposées de l'élément creux (5) et perpendiculairement aux faces opposées de l'élément creux (5). Chaque glissière (5a) est située à proximité d'un des deux côtés évidés du pourtour de la profondeur de l'élément creux (5) de façon à guider l'insertion du téléphone mobile (2) et à maintenir le téléphone mobile (2) dans l'élément creux (5). Dès lors, le téléphone mobile (2) ne peut être inséré dans l'élément creux (5) que par le côté évidé du pourtour de l'élément creux (5) opposé au côté plein du pourtour de l'élément creux (5). Le téléphone mobile (2) ne peut pas quitter son logement formé par l'élément creux (5) par les côtés du pourtour de l'élément creux (5) fermés par les glissières, et, l'utilisateur peut retirer le téléphone mobile (2) de l'élément creux (5) en pinçant le téléphone mobile (2) à travers les parties évidées des glissières (5a) et en le tirant hors de l'élément creux (5).

Comme précédemment introduit et comme illustré sur les figures 7, 8A et 8B, le cadre de protection (1 b) dans le troisième mode de réalisation comprend deux parties distinctes, chacune réalisée au moins en partie en matériau bon conducteur. La première partie formant un cadre (1ba) est fixée sur la face évidée de l'élément creux (5). Ce cadre (1ba) assure, d'une part, la concavité de l'élément de protection (1) et est, d'autre part, de dimension adaptée pour se trouver en vis-à-vis d'au moins le tiers de l'épaisseur du téléphone mobile (2) inséré dans l'élément creux (5). La seconde partie formant un cadre (1 bb) plan sert de support pour fixer en contact conducteur d'électricité les deux rails de coulissement (4c) du mécanisme de store.

Il nous reste à décrire l'agencement relatif :
- de l'élément creux (5) sur lequel est fixé le cadre (1 ba),
- du cadre (1bb) de section plane supportant les rails de coulissement (4c) du mécanisme de store, et
- du magasin (4a) du mécanisme de store dans lequel est monté enroulé autour de l'enrouleur-dérouleur (4b) le film mince (1ba) faisant office de store, et,
à rendre le tout esthétique, l'idée générale étant d'habiller les différents éléments du dispositif par une matière noble, par exemple du cuir, en conservant la caractéristique de protection biologique du dispositif.

Premièrement et comme illustré sur les figures 12A à 12C, l'élément creux (5) et le cadre (1 ba) formant une partie du cadre de protection (1 b) fixé sur la face évidée de l'élément creux (5) sont recouverts habillés par une matière souple fine, par exemple du cuir, de façon à masquer la structure plastique de l'élément creux (5), potentiellement fabriquée par moulage et donc exhibant des traces de moulage, et la structure métallique du cadre (1ba), potentiellement composée de plusieurs pièces métalliques et plastiques assemblées, pour que n'apparaisse à l'utilisateur qu'un étui uni et esthétique.

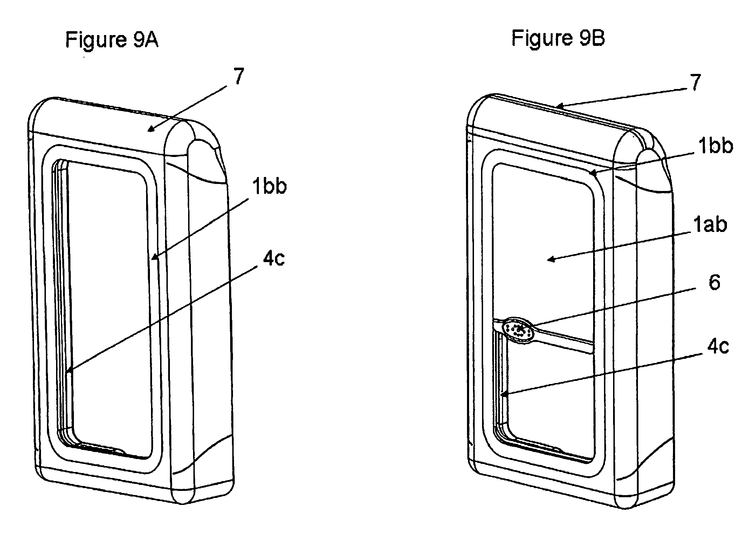

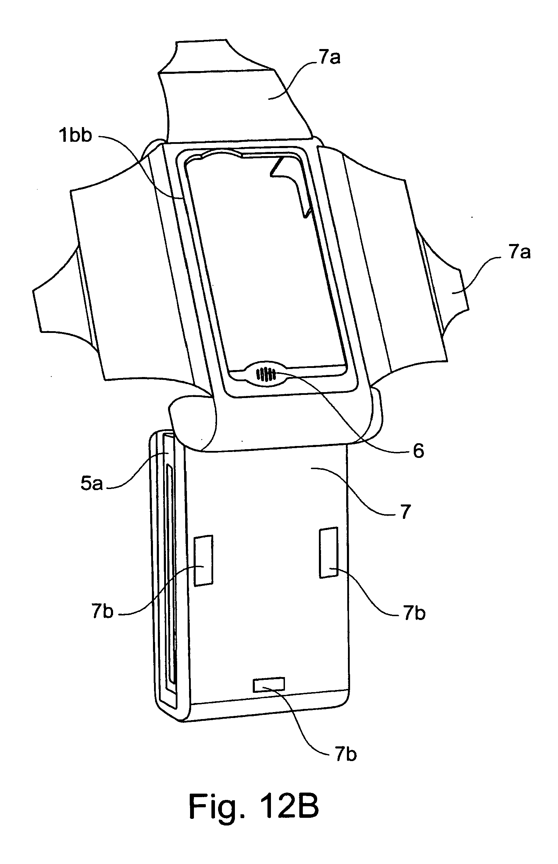

Deuxièmement et comme illustré sur la figure 12B, le cadre (1 bb) de section plane supportant les rails de coulissement (4c) du mécanisme de store et le magasin (4a) du mécanisme de store dans lequel est monté enroulé autour de l'enrouleur-dérouleur (4b) le film mince (1ba) faisant office de store sont intégrés dans un module (7).
D'une part et comme illustré sur les figures 9A, 9B, 11A et 11B, ce module (7) doit être agencé pour pouvoir se replier et se fixer sur l'étui de façon à ce que le cadre (1 bb) plan supportant les rails de coulissement (4c) et le magasin (4a) du mécanisme de store soient en contact conducteur d'électricité, et forment, avec le cadre (1ba), l'élément de protection (1) étanche aux ondes électromagnétiques et globalement concave.
D'autre part et comme illustré sur les figures 12A à 12C, le module (7) doit être agencé de façon à être amovible de l'étui pour que l'utilisateur puisse au besoin atteindre le téléphone mobile logé dans l'étui, par exemple pour l'en extraire ou utiliser la connectique.

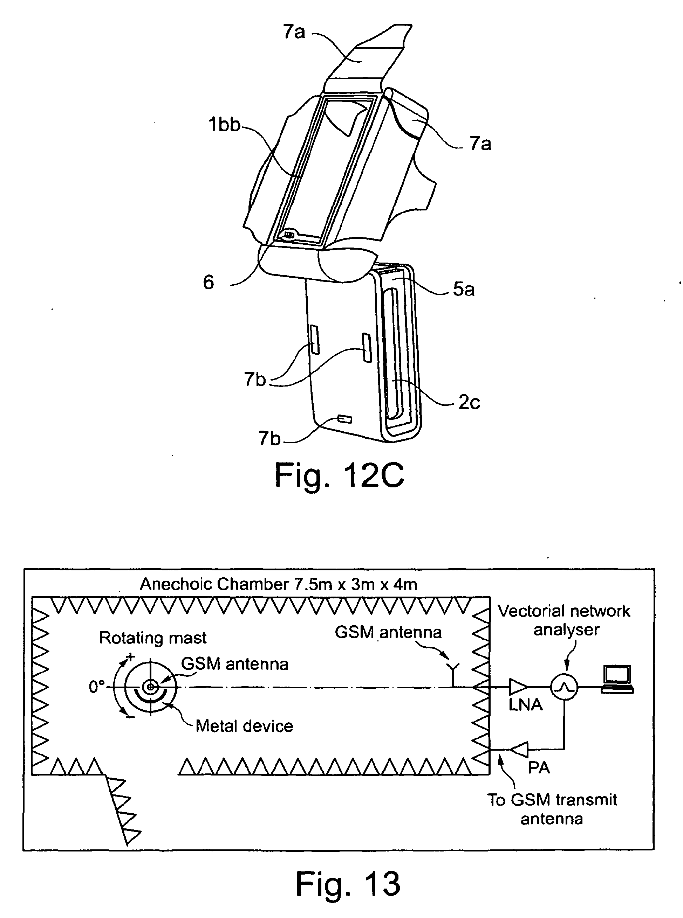

Pour atteindre ces objectifs, le module (7) prend une forme complexe, illustrée sur les figures 12A à 12C, présentant plusieurs caractéristiques.
Premièrement et comme illustré sur les figures 7, 8A, 8B, 10A et 10B, le magasin (4a) du mécanisme de store, une fois fermé par son couvercle (4ab) de forme et de dimensions adaptées pour laisser passer et guider le film mince (1 ab) faisant office de store vers les rails de coulissement (4c), présente une forme conceptuelle particulière adaptée, d'une part, pour épouser, par une partie de sa surface, la partie du pourtour extérieur du cadre (1 ba) se trouvant au plus près du haut-parleur du téléphone mobile (2), d'autre part, pour épouser, par l'autre partie de sa surface, une partie du patron qui lui est complémentaire en forme et en dimensions et sur laquelle le magasin est fixé. Deuxièmement et comme illustré sur les figures 10B, 12A, 12B et 12C, le cadre (1 bb) plan supportant les rails de coulissement (4c) est intégré dans de le module (7), les rails de coulissement (4c) se trouvant à l'intérieur du module (7) lorsque celui-ci est replié sur l'étui.
Troisièmement et comme illustré sur les figures 12A à 12C, le module (7) présente une pluralité de découpages et de charnières dessinant des languettes (7a) articulées sur le cadre (1 bb), les languettes (7a) permettant la libération des ouvertures prévues dans l'étui pour la connectique. Quatrièmement et comme illustré sur la figure 12A, les rails de coulissement (4c) fixés au cadre (1bb) plan se trouvent non seulement à l'intérieur du module (7) replié, mais également dans le prolongement de la sortie du magasin (4a) (cf. figure 5, 8A, 8B et 10A), de sorte que le film mince (1 ab) en position haute enroulé et bloqué par l'élément creusé (6) butant contre le cadre (1 bb) plan reste en partie engagé dans et entre les rails de coulissement (4c), et ce, que le module (7) soit déplié ou replié. Cinquièmement et comme illustré sur la figure 11B, les découpages et les charnières du module (7) sont agencés pour permettre aux languettes (7) de se fixer au dos de l'étui sur des velcros (7b) (cf. figures 12B et 12C) fixés au dos de l'étui en vis-à-vis de chaque languette (7a), de façon à maintenir scratché le module (7) autour de l'étui.

Pour finir, les différents modes de réalisation de l'élément de protection (1) ont fait le sujet d'une étude scientifique menée par le Pr. Joseph Saillard du laboratoire IREENA de l'université de Nantes et validant l'efficacité du dispositif de l'invention.

La figure 13 illustre schématiquement le banc de test situé dans une chambre anéchoïque et réalisé pour les mesures. Ce banc comprend un téléphone mobile (2), représenté par une antenne GSM et émettant une onde électromagnétique continue d'une fréquence de 940 MHz, un élément de protection (1) monté sur un mât rotatif, une antenne GSM de réception et des moyens de mesures situés à l'extérieur de la chambre anéchoïque.

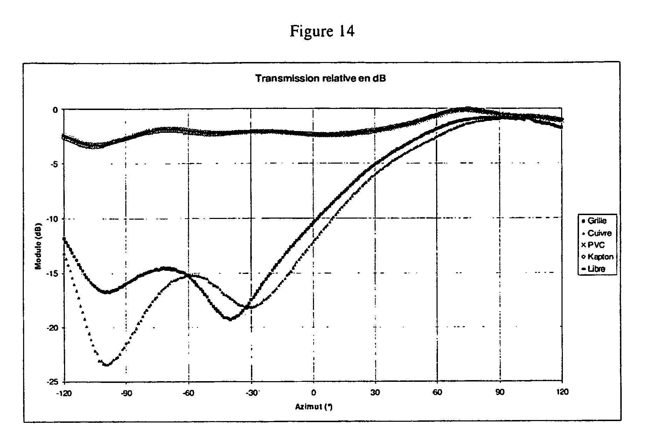

La figure 14 représente un graphe des mesures de transmission en fonction de l'angle du mât rotatif effectuées, tour à tour, sans élément de protection (1), avec le réseau métallique (1aa) réalisé en cuivre déposé sur une membrane en kapton, partiellement transparent dans le domaine du visible, puis avec une surface pleine en cuivre collé sur une membrane en PVC pour former le film mince (1 ab).

Trois groupes de courbes se détachent.
Les courbes du premier groupe, représentées par celles dont les variations dans la plage de mesures sont les plus faibles, correspondent aux relevés de transmission en fonction de l'angle du mât rotatif effectués, sans élément de protection (1) qu'il soit métallique ou non, puis avec les membranes en kapton et en PVC sans partie métallique. La variation d'atténuation sur la plage de mesures est de l'ordre de 3 dB. Les trois courbes se confondent.
La courbe du second groupe est celle obtenue en présence de la protection (1) métallique. Elle correspond à une atténuation de l'onde électromagnétique émise par le téléphone mobile (2) supérieure à 15 dB sur un secteur angulaire de 100°.
La courbe du troisième groupe correspond à l'atténuation en fonction de l'angle de déphasage provoquée par le réseau métallique (1aa) en cuivre déposé sur la membrane en kapton. Pour le même secteur angulaire de 100°, cette atténuation est supérieure à 12 dB.

Les différents modes de réalisation, décrits ci-dessus, du dispositif de protection selon l'invention peuvent être combinés de n'importe quelle façon appropriée, à moins qu'ils ne soient incompatibles entre eux. Dans la présente description, de nombreux détails spécifiques sont fournis à titre illustratif et nullement limitatif, de façon à détailler précisément l'invention. L'homme de métier comprendra cependant que l'invention peut être réalisée en l'absence d'un ou plusieurs de ces détails spécifiques ou avec des variantes. A d'autres occasions, certains aspects ne sont pas détaillés de façon à éviter d'obscurcir et alourdir la présente description et l'homme de métier comprendra que des moyens divers et variés pourront être utilisés et que l'invention n'est pas limitée aux seuls exemples décrits.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Dispositif de protection biologique contre les ondes électromagnétiques émises par un téléphone mobile, comportant :
un élément de protection (1) étanche aux ondes électromagnétiques réalisé, au moins en partie, en matériau métallique bon conducteur et agencé de façon à former un réceptacle ouvert globalement concave, approximativement de la forme d'un parallélépipède rectangle à angles arrondis dont la base forme un écran (1a) de protection plan ou légèrement concave disposé entre le téléphone mobile (2) et son utilisateur, et dont le pourtour de l'épaisseur forme un cadre (1b) de protection de section curviligne, de dimensions en longueur et en largeur respectivement supérieures aux dimensions en longueur et en largeur du téléphone mobile (2) l'écran (1a) et le cadre (1 b) étant réalisés au moins en partie en matériau bon conducteur et agencés de façon à ce que la partie réalisée en matériau bon conducteur de l'écran (1 a) soit en contact conducteur d'électricité avec la partie réalisée en matériau bon conducteur du cadre (1 b) pour former un tout étanche aux ondes électromagnétiques et globalement concave et courbé constituant en partie l'élément de protection (1),
le cadre (1 b) de protection étant de dimension, en épaisseur, supérieure à un tiers de l'épaisseur du pourtour du téléphone mobile,
le téléphone mobile (2) est maintenu dans la concavité de l'élément de protection (1) par au moins un organe (1c) de maintien ou de fixation
**caractérisé en ce que** l'organe (1c) de maintien ou de fixation est en matériau isolant non conducteur et disposé dans le réceptacle de façon à maintenir, de toute part, entre le téléphone mobile et la partie métallique de l'élément de protection un espace électriquement isolant d'une épaisseur d'au moins 2 mm.

2. Dispositif selon la revendication 1, **caractérisé en ce que** la longueur de l'élément de protection est égale ou supérieure à 1,15 fois la longueur du téléphone mobile, la largeur de l'élément de protection est égale ou supérieure à 1,2 fois la largeur du téléphone mobile, et la profondeur de l'élément de protection est égale ou supérieure à 1,3 fois l'épaisseur du téléphone mobile.

3. Dispositif selon la revendication 1 ou 2, **caractérisé en ce que** la longueur de l'élément de protection est inférieure ou égale à 1,3 fois la longueur du téléphone mobile, la largeur de l'élément de protection est inférieure ou égale à 1,3 fois la largeur du téléphone mobile, et la profondeur de l'élément de protection est inférieure ou égale à 1,6 fois l'épaisseur du téléphone mobile.

4. Dispositif selon la revendication 1, **caractérisé en ce que** l'espace électriquement isolant entre la partie métallique de l'élément de protection (1) et l'interface ergonomique du téléphone mobile (2) est d'une épaisseur comprise entre 3 mm et 8 mm.

5. Dispositif selon une des revendications 1 à 4, **caractérisé en ce que** l'écran (1a) et/ou le cadre (1b) de l'élément de protection (1) peut comporter un ou plusieurs orifices (3a) (cf. figure 1A) de taille inférieure aux différentes longueurs d'onde des ondes électromagnétiques des différentes normes de téléphonie mobile, l(es)' orifice(s) étant soit situé(s) en vis-à-vis du microphone et/ou du haut-parleur et/ou tout autre dispositif compris dans le téléphone mobile (2) et chargé de recevoir et/ou émettre des ondes acoustiques, de façon à ce que ces ondes acoustiques ne soient pas altérées par l'élément de protection (1), soit situé(s) en face des connectiques du téléphone mobile.

6. Dispositif selon une des revendications 1 à 5, **caractérisé en ce que** l'écran (1a) de l'élément de protection (1) comprend au moins un réseau (1aa) maillé réalisé en un matériau bon conducteur et ayant un pas de grille régulier ou non inférieur ou égal à 10 mm, le matériau bon conducteur constituant des lignes conductrices (1aaa) pouvant être d'une largeur de 0,5 mm et d'une épaisseur de 50 µm.

7. Dispositif selon la revendication 6, **caractérisé en ce que** le réseau maillé (1aa) conducteur est incorporé dans, ou imprimé par sérigraphie sur, une membrane ou intercalé dans une grille de trame plus fine, réalisée en un matériau souple transparent dans le domaine du visible de façon à permettre à l'utilisateur de voir l'interface ergonomique (2a) du téléphone mobile (2) et plus particulièrement l'écran d'affichage du téléphone mobile (2).

8. Dispositif selon les revendications 6 et 7, **caractérisé en ce que** l'écran (1a) plan ou légèrement concave est monté solidaire et tendu sur le cadre (1b) de l'élément de protection (1), qui comprend au moins une partie en matériau métallique bon conducteur à sa surface ou dans son épaisseur, de façon à ce que le réseau maillé (1aa) métallique constituant en partie l'écran (1a) soit en contact conducteur d'électricité avec la partie métallique du cadre (1b), pour former un tout étanche aux ondes électromagnétiques et globalement concave et courbé constituant en partie l'élément de protection (1).

9. Dispositif selon une des revendications 1 à 5, **caractérisé en ce que** l'écran (1a) de l'élément de protection (1) comprend au moins un film mince (1 ab).

10. Dispositif selon la revendication 9, **caractérisé en ce que** le film mince (1 ab) comprend au moins une partie de sa surface réalisée en matériau métallique bon conducteur, déposée sur, ou incorporée dans, une membrane réalisée en matériau souple, de façon à ce que le film mince (1ab) soit suffisamment souple pour être enroulable sur lui-même.

11. Dispositif selon la revendication 9, **caractérisé en ce que** le cadre (1 b) de l'élément de protection (1) comprend au moins une partie en matériau métallique bon conducteur et est agencé en une combinaison fonctionnelle avec au moins un mécanisme de store (4).

12. Dispositif selon la revendication 11, **caractérisé en ce que** chaque mécanisme de store (4) comprend un magasin (4a) de dimension et de forme adaptées pour pouvoir contenir au moins un store entièrement enroulé autour d'un enrouleur-dérouleur (4b), fixé par des moyens de fixation approximativement au centre du magasin (4a) et situé dans le plan de glissement du store, et un jeu de deux rails de coulissement (4c) parallèles au store et situés dans le plan de glissement du store pour guider le déplacement du store, la rigidité du store étant suffisante pour commander l'enroulement en remontant l'extrémité libre du store et le magasin (4a) du mécanisme de store (4) étant agencé relativement à un des quatre côtés du pourtour du cadre (1b) de protection.

13. Dispositif selon une des revendications 9 à 12, **caractérisé en ce que** les deux rails de coulissement (4c) sont réalisés au moins en partie en matériau bon conducteur, fixés sur le cadre (1 b) de façon à assurer un contact conducteur d'électricité avec la partie métallique du cadre (1b), et, chaque rail de coulissement (4c) est équipé d'une pluralité de lèvres conductrices (4d) distribuées à intervalles réguliers dans la longueur du rail de coulissement (4c) entre les jambes de la forme en U dessinée par le rail de coulissement (4c), chaque lèvre conductrice (4d) étant fixée en contact conducteur d'électricité sur une première des deux jambes de la forme en U et étant de forme et de dimension adaptées pour laisser un espace constant entre elles et la deuxième des deux jambes de la forme en U d'une épaisseur au moins égale à l'épaisseur du store.

14. Dispositif selon une des revendications 9 à 13, **caractérisé en ce que** le mécanisme de store (4) est agencé de façon à ce que le film mince (1 ab) conducteur, faisant office de store, puisse alternativement venir couvrir et mettre à découvert l'interface ergonomique (2a) du téléphone mobile ; les deux rails de coulissement (4c), le cadre (1b) et le film mince (1ab) étant agencés de façon à assurer une continuité du contact électrique entre les parties conductrices les constituants en partie pour former un tout étanche aux ondes électromagnétiques et globalement concave constituant en partie l'élément de protection (1), quand le film mince (1ab) est entièrement déroulé.

15. Dispositif selon une des revendications 9 à 14, **caractérisé en ce que** l'écran (1a) de protection comprenant le film mince (1ab) comprend un élément (6) de forme creusée et partiellement complémentaire du pouce de l'utilisateur fixé au film mince (1ab) pour faciliter à l'utilisateur la manipulation du film mince (1ab), faisant office de store, et pour jouer le rôle de butée pour empêcher que le film mince (1ab) disparaisse totalement dans le magasin (4a) du mécanisme de store (4).

16. Dispositif selon une des revendications 9 à 15, **caractérisé en ce que** le cadre (1b) de protection est surmonté d'un cadre (1d) plan en matériau isolant de dimension et de forme adaptées pour être monté solidaire dans le cadre (1b) de protection entre l'écran (1a) de protection et l'utilisateur pour protéger le mécanisme de store (4) et l'écran (1a) de protection, faisant office de store, sans pour autant occulter la vue à travers l'élément de protection (1) de l'interface ergonomique (2a) du téléphone mobile, et pour que le film mince (1ab) entièrement enroulé et bloqué par l'élément creusé (6) butant contre l'intérieur du pourtour du cadre plan (1d), reste en partie engagé dans et entre les rails de coulissement.

## Claims

1. Device for biological protection against the electromagnetic waves emitted by a mobile telephone, including:
- a protective element (1) which is proof against the electromagnetic waves and is made at least in part from a highly conductive metal material and arranged in such a way as to form an open generally concave receptacle, approximately in the shape of a rectangular parallelepiped with rounded corners of which the base forms a flat or slightly concave protective screen (1a) which is disposed between the mobile telephone (2) and its user, and of which the periphery forms a protective frame (1b) of curvilinear section, with length and width dimensions respectively greater than the length and width dimensions of the mobile telephone (2), the screen (1a) and the frame (1b) being made at least in part from a highly conductive material and arranged in such a way that the part of the screen (1a) made from a highly conductive material is in electrically conductive contact with the part of the frame (1b) made from a highly conductive material in order to form a whole which is proof against electromagnetic waves and is generally concave and curved so that it partially constitutes the protective element (1),
- the protective frame (1b) having a thickness dimension which is greater than one third of the thickness of the periphery of the mobile telephone,
- the mobile telephone (2) is retained in the concave space in the protective element (1) by at least one retention or fixing device (1c),
**characterised in that** the retention or fixing device (1c) is made from a non-conductive insulating material and is disposed in the receptacle in such a way as to maintain, on all sides, an electrically insulating space with a thickness of at least 2 mm between the mobile telephone and the metal part of the protective element and the mobile telephone.

2. Device as claimed in Claim 1, **characterised in that** the length of the protective element is equal to or greater than 1.15 times the length of the mobile telephone, the width of the protective element is equal to or greater than 1.2 times the width of the mobile telephone, and the depth of the protective element is equal to or greater than 1.3 times the thickness of the mobile telephone.

3. Device as claimed in Claim 1 or 2, **characterised in that** the length of the protective element is less than or equal to 1.3 times the length of the mobile telephone, the width of the protective element is less than or equal to 1.3 times the width of the mobile telephone, and the depth of the protective element is less than or equal to 1.6 times the thickness of the mobile telephone.

4. Device as claimed in Claim 1, **characterised in that** the electrically insulating space between the metal part of the protective element (1) and the ergonomic interface of the mobile telephone has a thickness between 3 mm and 8 mm.

5. Device as claimed in any one of Claims 1 to 4, **characterised in that** the screen (1a) or/and the frame (1b) of the protective element (1) can include one or more orifices (3a) (cf. Figure 1A) of a size which is less than the various wavelengths of the electromagnetic waves used in various mobile telephone standards, this orifice or these orifices being either situated opposite the microphone and/or the loudspeaker and/or any other device included in the mobile telephone (2) and used to receive and/or transmit acoustic waves in such a way that these acoustic waves are not altered by the protective element (1), or situated opposite the connectors of the mobile telephone.

6. Device as claimed in any one of Claims 1 to 5, **characterised in that** the screen (1a) of the protective element (1) includes at least one mesh grid (1aa) made from a highly conductive material and having a grid pitch, which may or may not be regular, equal to or less than 10 mm, the highly conductive material constituting conductive lines (1aaa) which can have a width of 0.5 mm and a thickness of 50 µm.

7. Device as claimed in Claim 6, **characterised in that** the conductive mesh grid (1aa) is incorporated into or screen printed onto a membrane or is interwoven into a grid of finer mesh made from a flexible material which is transparent in the visible spectrum in such a way as to allow the user to see the ergonomic interface (2a) of the mobile telephone (2) and more particularly the display screen of the mobile telephone (2).

8. Device as claimed in Claims 6 and 7, **characterised in that** the flat or slightly concave screen (1a) is attached to and stretched over the frame (1b) of the protective element (1), which includes at least one part made from a highly conductive metal material on its surface or within its thickness, in such a way that the metal mesh grid (1aa) partially constituting the screen (1a) is in electrically conductive contact with the metal part of the frame (1b) in order to form a whole which is proof against electromagnetic waves and generally concave and curved so that it partially constitutes the protective element (1).

9. Device as claimed in any one of Claims 1 to 5, **characterised in that** the screen (1a) of the protective element (1) comprises at least one thin film (1ab).

10. Device as claimed in Claim 9, **characterised in that** the thin film (1ab) comprises at least one part of its surface made from a highly conductive metal material deposited onto or incorporated into a membrane made from a flexible material in such a way that the thin film (1ab) is sufficiently flexible to be rolled back onto itself.

11. Device as claimed in Claim 9, **characterised in that** the frame (1b) of the protective element (1) comprises at least one part made from a highly conductive metal material and is arranged in a functional combination with at least one roller shutter mechanism (4).

12. Device as claimed in Claim 11, **characterised in that** each roller shutter mechanism (4) comprises a store (4a) of which the dimensions and shape are adapted to be able to contain at least one roller shutter completely rolled around a roll-unroll mechanism (4b), fixed by fixing means approximately at the centre of the store (4a) and situated in the sliding plane of the roller shutter, and a set of two sliding rails (4c) parallel to the roller shutter and situated in the sliding plane of the roller shutter in order to guide the movement of the roller shutter, the rigidity of the roller shutter being sufficient to control the rolling by raising the free end of the roller shutter, and the store (4a) of the roller shutter mechanism being arranged relative to one of the four sides of the periphery of the protective frame (1b).

13. Device as claimed in any one of Claims 9 to 12, **characterised in that** the two sliding rails (4c) are made at least in part from a highly conductive material, are fixed on the frame (1b) in such a way as to ensure an electrically conductive contact with the metal part of the frame (1b), and each sliding rail (4c) is equipped with a plurality of conductive lips (4d) distributed at regular intervals over the length of the sliding rail (4c) between the legs of the U shape formed by the sliding rail (4c), each conducting lip (4d) being fixed in electrically conductive contact on a first of the two legs of the U shape and having a shape and dimensions adapted to leave a constant space between them and the second of the two legs of the U shape with a depth at least equal to the thickness of the roller shutter.

14. Device as claimed in any one of Claims 9 to 13, **characterised in that** the roller shutter mechanism (4) is arranged in such a way that the conductive thin film (1ab) which serves as the roller shutter can alternatively cover and uncover the ergonomic interface (2a) of the mobile telephone; the two sliding rails (4c), the frame (1b) and the thin film (1ab) being arranged in such a way as to ensure continuity of the electrical contact between the conductive parts which partially constitute them in order to form a whole which is proof against the electromagnetic waves and generally concave so that it partially constitutes the protective element (1), when the thin film (1ab) is completely unrolled.

15. Device as claimed in any one of claims 9 to 14, **characterised in that** the protective screen (1a) comprising the thin film (1ab) comprises an element (6) which is of hollowed-out shape and partially complementary to the thumb of the user and is fixed onto the thin film (1ab) in order to enable the user to manipulate the thin film (1ab) serving as the roller shutter and to play the role of a stop element in order to prevent the thin film (1ab) from disappearing completely into the store (4a) for the roller shutter mechanism (4).

16. Device as claimed in any one of Claims 9 to 15, **characterised in that** the protective frame (1b) is surmounted by a flat frame (1d) made from insulating material which has dimensions and a shape adapted to be attached to the protective frame (1b) between the protective screen (1a) and the user in order to protect the roller shutter mechanism (4) and the protective screen (1a) which serves as the roller shutter, but without obscuring the view through the protective element (1) of the ergonomic interface (2a) of the mobile telephone, and so that the thin film (1ab) which is completely rolled up and locked by the hollowed-out element (6) butting against the interior of the periphery of the flat frame (1d), remains partially engaged in and between the sliding rails.

## Patentansprüche

1. Vorrichtung zum biologischen Schutz vor durch ein Mobiltelefon ausgesendeten elektromagnetischen Wellen, aufweisend:
ein gegenüber elektromagnetischen Wellen dichtes Schutzelement (1), das zumindest teilweise aus einem gut leitenden Metallmaterial hergestellt ist und derart eingerichtet ist, dass es eine im Wesentlichen konkave offene Aufnahme ausbildet, die annähernd die Form eines rechteckigen Parallelepipeds mit abgerundeten Ecken hat, deren Basis einen ebenen oder leicht konkaven Schutzschirm (1a) ausbildet, der zwischen dem Mobiltelefon (2) und dessen Benutzer angeordnet ist und dessen Dickenumfang einen Schutzrahmen (1b) mit einem gekrümmten Querschnitt ausbildet, mit einer Längen- und einer Breitenabmessung, die jeweils größer als die Längen- und die Breitenabmessung des Mobiltelefons (2) sind, wobei der Schirm (1a) und der Rahmen (1b) zumindest teilweise aus einem gut leitenden Material hergestellt sind und derart eingerichtet sind, dass der aus gut leitendem Material hergestellte Teil des Schirms (1a) in elektrisch leitendem Kontakt mit dem aus einem gut leitenden Material hergestellten Teil des Rahmens (1b) ist, um eine gegenüber elektromagnetischen Wellen dichte und im Wesentlichen konkave und gekrümmte Gesamtheit auszubilden, die das Schutzelement (1) teilweise ausbildet,
wobei der Schutzrahmen (1b) in der Dicke eine Abmessung hat, die größer als ein Drittel der Dicke des Umfangs des Mobiltelefons ist,
wobei das Mobiltelefon (2) durch mindestens ein Halte- oder Befestigungsmittel (1c) in der Vertiefung des Schutzelements (1) gehalten ist,
**dadurch gekennzeichnet, dass** das Halte- oder Befestigungsmittel (1c) aus einem isolierenden, nicht leitenden Material hergestellt ist und in der Aufnahme angeordnet ist, um überall zwischen dem Mobiltelefon und dem Metallteil des Schutzelements einen elektrisch isolierenden Raum mit einer Dicke von mindestens 2 mm aufrechtzuerhalten.

2. Vorrichtung gemäß Anspruch 1, **dadurch gekennzeichnet, dass** die Länge des Schutzelements größer oder gleich dem 1,15-fachen der Länge des Mobiltelefons ist, die Breite des Schutzelements größer oder gleich dem 1,2-fachen der Breite des Mobiltelefons ist, und die Tiefe des Schutzelements größer oder gleich dem 1,3-fachen der Dicke des Mobiltelefons ist.

3. Vorrichtung gemäß Anspruch 1 oder 2, **dadurch gekennzeichnet, dass** die Länge des Schutzelements kleiner oder gleich dem 1,3-fachen der Länge des Mobiltelefons ist, die Breite des Schutzelements kleiner oder gleich dem 1,3-fachen der Breite des Mobiltelefons ist, und die Tiefe des Schutzelements kleiner oder gleich dem 1,6-fachen der Dicke des Mobiltelefons ist.

4. Vorrichtung gemäß Anspruch 1, **dadurch gekennzeichnet, dass** der elektrisch isolierende Raum zwischen dem Metallteil des Schutzelements (1) und der ergonomischen Schnittstelle des Mobiltelefons (2) eine Dicke von zwischen 3 mm und 8 mm hat.

5. Vorrichtung gemäß einem der Ansprüche 1 bis 4, **dadurch gekennzeichnet, dass** der Schirm (1a) und/oder der Rahmen (1b) des Schutzelements (1) eine oder mehr Öffnungen (3a) (vgl. Fig. 1A) aufweisen können/kann, mit einer Größe, die kleiner als die verschiedenen Wellenlängen der elektromagnetischen Wellen der verschiedenen Mobiltelefoniestandards ist, wobei die Öffnung(en) entweder gegenüber dem Mikrofon und/oder dem Lautsprecher und/oder jeder anderen in dem Mobiltelefon (2) vorgesehenen und für das Empfangen und/oder Aussenden von Schallwellen vorgesehenen Vorrichtung angeordnet ist (sind), so dass die Schallwellen nicht durch das Schutzelement (1) beeinträchtigt werden, oder gegenüber der Anschlusstechnik des Mobiltelefons angeordnet ist (sind).

6. Vorrichtung gemäß einem der Ansprüche 1 bis 5, **dadurch gekennzeichnet, dass** der Schirm (1a) des Schutzelements (1) mindestens ein Maschennetz (1aa) aufweist, das aus einem gut leitenden Material ausgebildet ist und einen Gitterabstand aufweist, der regelmäßig oder nicht kleiner oder gleich 10 mm ist, wobei das gut leitende Material leitfähige Leitungen (1aaa) ausbildet, die eine Breite von 0,5 mm und eine Dicke von 50 µm haben können.

7. Vorrichtung gemäß Anspruch 6, **dadurch gekennzeichnet, dass** das leitende Maschennetz (1aa) in eine Membran integriert oder mittels Siebdruck auf diese aufgedruckt ist oder in ein Gitter mit einer feineren Rasterung eingefügt ist, das aus einem nachgiebigen transparenten Material im sichtbaren Bereich realisiert ist, um dem Benutzer zu ermöglichen, die ergonomische Schnittstelle (2a) des Mobiltelefons (2) und insbesondere den Anzeigebildschirm des Mobiltelefon (2) zu sehen.

8. Vorrichtung gemäß den Ansprüchen und 7, **dadurch gekennzeichnet, dass** der ebene oder leicht konkave Schirm (1a) einstückig und gespannt am Rahmen (1b) des Schutzelements montiert ist, der mindestens einen Teil aus gut leitendem Metallmaterial an seiner Oberfläche oder in seiner Dicke aufweist, so dass das Maschennetz (1aa) aus Metall, das den Schirm (1a) teilweise ausbildet, in elektrisch leitendem Kontakt mit dem Metallteil des Rahmens (1b) ist, um eine elektromagnetischen Wellen gegenüber dichte und im Wesentlichen konkave und gekrümmte Gesamtheit auszubilden, die das Schutzelement (1) teilweise ausbildet.

9. Vorrichtung gemäß einem der Ansprüche 1 bis 5, **dadurch gekennzeichnet, dass** der Schirm (1a) des Schutzelements (1) mindestens einen dünnen Film (1ab) aufweist.

10. Vorrichtung gemäß Anspruch 9, **dadurch gekennzeichnet, dass** zumindest ein Teil der Fläche des dünnen Films (1ab) aus einem gut leitenden Metallmaterial realisiert ist, wobei dieser auf eine Membran aus nachgiebigem Material aufgebracht oder in diese integriert ist, derart, dass der dünne Film (1ab) ausreichend nachgiebig ist, um zusammenrollbar zu sein.

11. Vorrichtung gemäß Anspruch 9, **dadurch gekennzeichnet, dass** der Rahmen (1b) des Schutzelements (1) zumindest einen Teil aus gut leitendem Metallmaterial aufweist und in einer Funktionskombination mit mindestens einem Jalousiemechanismus (4) eingerichtet ist.

12. Vorrichtung gemäß Anspruch 11, **dadurch gekennzeichnet, dass** jeder Jalousiemechanismus (4) aufweist: einen Speicherbereich (4a) mit einer Abmessung und Form, die angepasst sind, um mindestens ein vollständig um eine Aufroll-Abroll-Einrichtung (4b) gewickelte Jalousie aufweisen zu können, die mittels Befestigungsmitteln ungefähr in der Mitte des Speicherbereichs (4a) befestigt ist und in der Gleitebene der Jalousie angeordnet ist, und einen Satz von zwei Gleitschienen (4c), die parallel zu der Jalousie sind und in der Gleitebene der Jalousie angeordnet sind, um die Bewegung der Jalousie zu führen, wobei die Steifigkeit der Jalousie ausreichend ist, um das Aufrollen durch Anheben des freien Endes der Jalousie zu steuern, und wobei der Speicherbereich (4a) des Jalousiemechanismus (4) bezüglich einer der vier Seiten des Umfangs des Schutzrahmens (1b) angeordnet ist.

13. Vorrichtung gemäß einem der Ansprüche 9 bis 12,
**dadurch gekennzeichnet, dass** die beiden Gleitschienen (4c) zumindest teilweise aus einem gut leitenden Material realisiert sind, derart an dem Rahmen (1b) befestigt sind, dass ein elektrisch leitender Kontakt mit dem Metallteil des Rahmens (1b) sichergestellt ist, und jede Gleitschiene (4c) mit einer Mehrzahl von leitenden Lippen (4d) ausgestattet ist, die in regelmäßigen Abständen entlang der Länge der Gleitschiene (4c) zwischen den Schenkeln der U-Form verteilt sind, die durch die Gleitschiene (4c) definiert ist, wobei jede leitende Lippe (4d) in elektrisch leitendem Kontakt an einem ersten der beiden Schenkel der U-Form befestigt ist und eine Form und Abmessung hat, die angepasst sind, um einen durchgängigen Raum zwischen einander und dem zweiten der beiden Schenkel der U-Form mit einer Dicke zu lassen, die mindestens gleich der Dicke der Jalousie ist.

14. Vorrichtung gemäß einem der Ansprüche 9 bis 13,
**dadurch gekennzeichnet, dass** der Jalousiemechanismus (4) derart eingerichtet ist, dass der dünne leitende Film (1ab), der als Jalousie dient, die ergonomische Schnittstelle (2a) des Mobiltelefons abwechselnd bedecken und freilegen kann, wobei die beiden Gleitschienen (4c), der Rahmen (1b) und der dünne Film (1ab) derart eingerichtet sind, dass sie eine Durchgängigkeit des elektrischen Kontaktes zwischen den sie teilweise ausbildenden leitenden Abschnitten sicherstellen, um eine gegenüber elektromagnetischen Wellen dichte und im Wesentlichen konkave Gesamtheit auszubilden, die das Schutzelement (1) teilweise ausbildet, wenn der dünne Film (1ab) vollständig abgerollt ist.

15. Vorrichtung gemäß einem der Ansprüche 9 bis 14,
**dadurch gekennzeichnet, dass** der den dünnen Film (1ab) aufweisende Schutzschirm (1a) aufweist: ein Element (6) mit vertiefter und zu dem Daumen des Benutzers teilweise komplementärer Form, das an dem dünnen Film (1ab) befestigt ist, um dem Benutzer die Bedienung des als Jalousie dienenden dünnen Films (1ab) zu erleichtern, und um die Rolle eines Anschlags zu spielen, um zu verhindern, dass der dünne Film (1ab) vollständig in dem Speicherbereich (4a) des Jalousiemechanismus (4) verschwindet.

16. Vorrichtung gemäß einem der Ansprüche 9 bis 15,
**dadurch gekennzeichnet, dass** der Schutzrahmen (1b) von einem ebenen Rahmen (1d) aus isolierendem Material überragt wird, dessen Abmessung und Form angepasst sind, um einstückig in dem Schutzrahmen (1b) zwischen dem Schutzschirm (1a) und dem Benutzer montiert zu sein, um den Jalousiemechanismus (4) und den Schutzschirm (1a) zu schützen, der als Jalousie dient, ohne dabei die Sicht durch das Schutzelement (1) der ergonomischen Schnittstelle (2a) des Mobiltelefons hindurch zu verdecken, und damit der vollständig aufgerollte und von dem an das Innere des Umfangs des ebenen Rahmens (1d) anstoßenden vertieften Element (6) blockierte dünne Film (1ab) teilweise mit und zwischen den Gleitschienen in Eingriff bleibt.
